(19) Europäisches Patentamt
European Patent Office
Office européen des brevets

(11) EP 1 577 935 A2

(12) # EUROPEAN PATENT APPLICATION

(43) Date of publication:
**21.09.2005 Bulletin 2005/38**

(51) Int Cl.[7]: **H01L 21/316**, C01B 33/16

(21) Application number: **05004343.9**

(22) Date of filing: **28.02.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **02.03.2004 US 549251 P**
**18.02.2005 US 60371 P**

(71) Applicant: **AIR PRODUCTS AND CHEMICALS, INC.**
**Allentown, PA 18195-1501 (US)**

(72) Inventors:
- **Weigel, Scott Jeffrey**
**Allentwon PA 18104 (US)**
- **Khot, Shrikant Narendra**
**Annandale NJ 08801 (US)**
- **MacDougall, James Edward**
**New Tripoli PA 18066 (US)**
- **Braymer, Thomas Albert**
**Allentown PA 18103 (US)**
- **Kirner, John Francis**
**Orefield PA 18069 (US)**
- **Peterson, Brian Kieth**
**Fogelsville PA 18051 (US)**

(74) Representative: **Kador & Partner**
**Corneliusstrasse 15**
**80469 München (DE)**

(54) **Compositions for preparing low dielectric materials containing solvents**

(57) Silica-based materials and films having a dielectric constant of 3.7 or below and compositions and methods for making and using same are disclosed herein. In one aspect, there is provided a composition for preparing a silica-based material comprising an at least one silica source, a solvent, an at least one porogen, optionally a catalyst, and optionally a flow additive wherein the solvent boils at a temperature ranging from 90°C to 170°C and is selected from the group of compounds represented by the following formulas: $HO-CHR^8-CHR^9-CH_2-CHR^{10}R^{11}$ where $R^8$, $R^9$, $R^{10}$ and $R^{11}$ can independently be an alkyl group ranging from 1 to 4 carbon atoms or a hydrogen atom; and $R^{12}-CO-R^{13}$ where $R^{12}$ is a hydrocarbon group having from 3 to 6 carbon atoms; $R^{13}$ is a hydrocarbon group having from 1 to 3 carbon atoms; and mixtures thereof.

EP 1 577 935 A2

## Description

CROSS-REFERENCE TO RELATED APPLICATIONS

This application claims the benefit of U.S. Provisional Application No. 60/549,251, filed 2 March 2004.

BACKGROUND

The present invention relates generally to a material suitable for use, for example, in electronic devices.

There is a continuing desire in the microelectronics industry to increase the circuit density in multilevel integrated circuit devices such as memory and logic chips in order to improve the operating speed and reduce power consumption. In order to continue to reduce the size of devices on integrated circuits, it has become necessary to use insulators having a low dielectric constant to reduce the resistance-capacitance ("RC") time delay of the interconnect metallization and to prevent capacitive cross talk between the different levels of metallization. Such low dielectric materials are desirable for premetal dielectric layers and interlevel dielectric layers.

Typical dielectric materials for devices with 180 nm line width are materials with a dielectric constant between about 3.8 and 4.2. As the line width decreases, the dielectric constant should also be decreased. For example, devices with 130 nm line width require materials with a dielectric constant between about 2.5 and 3.0. Extremely low dielectric constant ("ELK") materials generally have a dielectric constant between about 2.0 and 2.5. Devices with 90 nm line width require materials with dielectric constants less than 2.4.

A number of processes have been used for preparing low dielectric constant films. Chemical vapor deposition (CVD) and spin-on dielectric (SOD) processes are typically used to prepare thin films of insulating layers. A wide variety of low $\kappa$ materials deposited by these techniques have been generally classified in categories such as purely inorganic materials, ceramic materials, silica-based materials, purely organic materials, or inorganic-organic hybrids. Likewise, a variety of processes have been used for curing these materials to decompose and/or remove volatile components and substantially crosslink the films such as heating, treating the materials with plasmas, electron beams, or UV radiation.

Since the dielectric constant of air is nominally 1.0, one approach to reducing the dielectric constant of a material may be to introduce porosity. Porosity has been introduced in low dielectric materials through a variety of different means. A dielectric film when made porous may exhibit lower dielectric constants compared to a dense film, however, the elastic modulus of the film generally decreases with increasing porosity. Consequently, it may be impractical to use these low dielectric compositions due to the trade-off in dielectric constant with elastic modulus.

The dielectric constant ($\kappa$) of a material generally cannot be reduced without a subsequent reduction in the mechanical properties, i.e., modulus, hardness, etc., of the material. Mechanical strength is needed for subsequent processing steps such as etching, CMP ("Chemical Mechanical Planarization"), and depositing additional layers such as diffusion barriers for copper, copper metal ("Cu"), and cap layers on the product. In some of these processes, temperature cycling of multiple layers may induce stresses due to the thermal coefficient of expansion mismatch between the different materials thereby causing cracking or delamination. Surface planarity is also required and may be maintained through controlling processing parameters such as those during the film formation process and also through CMP. Mechanical integrity, or stiffness, compressive, and shear strengths, may be particularly important to survive CMP.

Another consideration in the production of low dielectric materials and the resultant film is the level of metal impurities present in the material. In order for a low dielectric film to be suitable for integrated circuit (IC) fabrication, it is desirable that the film has a controlled level of impurities. In other words, the film should be deposited using ingredients that have minimal levels of nonvolatile impurities that may be harmful in silicon oxide-based insulator films in microelectronic devices. In the IC industry, it is well known that alkali metal ions such as sodium and potassium should be excluded from silicon dioxide films used as metal oxide semiconductor ("MOS") transistor insulators and multilevel interconnection insulators.

Some commercially available chemical reagents used in the production of low dielectric films contain alkali metal impurities. These impurities may result from residual levels of catalyst used in the manufacture of the chemical precursor reagents. Ratios of 0.005-0.05:1 mol of NaOH, KOH, or $NaOCH_3$ to alcohol are frequently used in the base-catalyzed ethoxylation of aliphatic alcohols, alkylphenols, and fatty acids. See, e.g., Lynn et al.,"Surfactants", Kirk-Othmer Encyclopedia of Chemical Technology, John Wiley & Sons, Inc., (1997). For example, the use of 0.005 mol NaOH per mol of alcohol in the production of TRITON™ X-114, an alkylphenol ethoxylate with an average 7.5 moles of ethoxylate per mole of alcohol, may result in 214 ppm of sodium in the final product. Such levels of residual catalytic impurities are often of little consequence in typical applications of these chemicals because the surfactant is often used at such low levels that the catalytic impurities imparted by the surfactant become insignificant in the final formulation. A polymer such as polyethylene glycol (PEG) may be made using different catalyst systems depending on the desired molecular weight. For molecular weight below 20,000, base or the $Na^+$ or $K^+$ alkoxides of methanol or butanol are used

as the catalyst. See, for instance, Glass, J. E. "Water-Soluble Polymers", Kirk-Othmer Encyclopedia of Chemical Technology, John Wiley & Sons, Inc. (1988). Solvents, like surfactants, can also contain residual catalytic impurities. For instance, the formation of ethers, such as propylene glycol propyl ether (PGPE), through the reaction of propylene oxide with an alcohol, is often base-catalyzed when high selectivity to the primary alkyl ether over the secondary ether is desired which can result in residual impurities. See, for instance, Brown, et al., "Glycols: Ethylene Glycol and Propylene Glycol", Kirk-Othmer Encyclopedia of Chemical Technology, 3rd ed., John Wiley & Sons, N.Y., (1980), Vol. 11, p 953. A further source of impurities may result from an inattention to detail, such as packaging or handling outside a clean room, because such stringent purity requirements are not needed for typical applications.

Alkali metal impurity specifications for chemical precursor solutions for integrated circuit applications typically set the allowable impurity levels to approximately 20 parts per billion maximum for each type of alkali metal and less than 50 ppb total. To meet these limits, the material supplier to the IC industry may purify the reagents. The reference, EP 1,142,832, assigned to the assignee of the present application, discusses how the dielectric and mechanical properties of the resulting films may be adversely affected by the purification of surfactants used as porogens in the film-forming mixture. U. S. Pat. No. 6,472,079 discusses how the dielectric properties of the resulting films may be adversely affected by the purification of reagents even if surfactant is not present.

The following references, U.S. Pat. Nos. 6,406,794, 6,329,017, 6,495,479, 6,126,733, U. S. Pat. App. Serial No. 2002/0189495, EP 1123753, and Chem. Mater. 2001 13, 2762 and 1848, provide various compositions used for forming dielectric films that include chemical reagents such as at least one source for silicon, a porogen, and a solvent. These references fail to disclose the purification of the chemical reagents, particularly porogens, prior to addition to the composition to remove alkali metal impurities. Some references, such as U. S. Pat. No. 6,376,634 and 6,126,733, discuss purifying the reagents prior to addition to the composition. However, as mentioned previously, in certain instances the purification process may adversely affect the dielectric constant and/or mechanical properties of the material.

As mentioned above, solvents are a typical ingredient used in spin-on dielectric film formulations. In these formulations, the solvent used to deposit films onto substrates should evaporate in a reasonable amount of time, e.g., < 5 minutes and provide highly uniform, defect-free films.

The ability to produce highly uniform, defect-free films are imperative to the successful integration of the SOD film into the IC structure. The SOD film may be formed using a closed, a semi-closed, or an open spinning bowl configuration. In a closed spinning bowl configuration, there is a lid present on the spinning chamber that remains closed during the spreading, thinning, and drying of the film. This configuration allows for environmental control of the atmosphere above the wafer thus making it easier to control the evaporation process of the solvent as the film forms and minimizes film defects such as striations or thickness variations across the wafer. Like the closed spinning bowl configuration, a semi-closed spinning bowl configuration has a lid or platen present that can be adjusted throughout the film formation process but does allow for the film to be exposed to environmental conditions during dispense and film formation. Adjustment of the lid or platen controls the turbulence and evaporation process of the solvent as it leaves the film allowing for excellent control of the film forming process. In an open spinning bowl configuration, there is no lid present on the process tool . Therefore, the dispense, spreading, thinning, and drying steps may be more dependent upon the solvents used in the mixture since there is no altemative physical means to change the evaporation characteristics of the solvent.

In the semi-closed and open bowl spinning bowl configuration, the film forming composition and wafer are more sensitive to environmental conditions; thus, controlling the evaporation rate of solvent within the bowl is difficult. This requires that the properties of the solvent in the film forming composition, i.e., temperature at which the solvent boils, surface tension, viscosity, and evaporation rate, to be used in a semi-closed or an open bowl configuration are appropriate to minimize defects and maintain uniformity across the wafer. If the solvent properties are not adequate, film defects, such as striations, holes, swirls, thickness inhomogeneities, can occur which can cause device failures during subsequent processing.

Yet another relevant attribute of a film forming composition is the room temperature storage stability. Stability of the film forming solution is defined as maintaining the thickness, refractive index, dielectric constant, and mechanical properties of the film produced from the film forming composition as the composition is stored under ambient conditions. Room temperature storage stability may reduce the costs attributed to refrigerated storage and process tool down time due to unscheduled tool interruptions that may entail draining, flushing, re-filling, and re-qualifying the chemical lines plus providing for manageable inventory control. In a reactive system, wherein one or more of the film-forming composition components are unreacted, the storage stability is typically shorter than a composition containing a completely reacted polymer.

## BRIEF SUMMARY

Silica-based materials and films having a dielectric constant of 3.7 or below and compositions and methods

for making same are described herein.

In one aspect, there is provided a composition for producing a silica-based material having a dielectric constant of about 3.7 or less comprising: an at least one silica source, a solvent, an at least one porogen, optionally a catalyst, and optionally a flow additive wherein the solvent boils at a temperature ranging from 90°C to 170°C and is selected from the group of compounds represented by the following formulas: $HO-CHR^8-CHR^9-CH_2-CHR^{10}R^{11}$ where $R^8$, $R^9$, $R^{10}$ and $R^{11}$ can independently be an alkyl group ranging from 1 to 4 carbon atoms or a hydrogen atom; and $R^{12}-CO-R^{13}$ where $R^{12}$ is a hydrocarbon group having from 3 to 6 carbon atoms; $R^{13}$ is a hydrocarbon group having from 1 to 3 carbon atoms; and mixtures thereof.

In another aspect, there is provided a composition for forming a silica-based film having a dielectric constant of about 3.7 or less comprising: an at least one silica source, a solvent, optionally an at least one porogen, optionally a catalyst, and a flow additive.

In yet another aspect, there is provided a process for forming a silica-based film with a dielectric constant of 3.7 or less comprising: providing a composition comprising: an at least one silica source, a solvent, optionally an at least one porogen, optionally an at least one catalyst, and optionally a flow additive wherein the solvent boils at a temperature ranging from 90°C to 170°C; depositing the composition onto a substrate using a bowl configuration selected from an open spinning bowl configuration and a semi-closed spinning bowl configuration to form a coated substrate; and curing the coated substrate to form the silica-based film.

In a still further aspect, there is provided a process for forming a silica-based film having a dielectric constant of 3.7 or less comprising: providing a composition comprising: an at least one silica source, an at least one solvent, water, and a catalyst wherein the at least one silica source partially hydrolyzes to provide a low boiling solvent; removing from the composition from about 20 to about 75% of the total number of moles of low boiling solvents and from 20 to 80% of the total number of moles of water to provide a reduced composition; depositing the reduced composition onto a substrate using a bowl configuration selected from an open spinning bowl configuration and a semi-closed spinning bowl configuration to form a coated substrate; and curing the coated substrate to one or more temperatures for a time sufficient to form the silica-based film.

In yet another aspect, there is provided a process for forming a silica-based film with a dielectric constant of 3.7 or less comprising: providing a composition comprising an at least one silica source, a solvent, optionally at least one porogen, optionally a catalyst, and a flow additive; depositing 3 milliliters or less of the composition onto a substrate to form a coated substrate wherein the depositing is conducted in a continuous stream; and curing the coated substrate to one or more temperatures for a time sufficient to form the silica-based film.

DETAILED DESCRIPTION

Silica-based, low dielectric materials and films and compositions and methods for making and using same are described herein. The materials and films have relatively low metal content and allow for ease of manufacture in comparison to other materials in the art. The terms "silicon-based" and "silica-based" are used interchangeably throughout the specification. Although the material described herein is particularly suitable for providing films and the products are largely described herein as films, it is not limited thereto. The material described herein can be provided in any form capable of being deposited by spin-on deposition or other techniques, such as, but not limited to, coatings, multilaminar assemblies, and other types of objects that are not necessarily planar or thin, and a multitude of objects not necessarily used in integrated circuits. The material or film described herein may be used, for example, in electronic devices.

The films described herein may be formed from a composition referred to herein as a film-forming composition. The composition may be prepared prior to forming the film or, alternatively, the composition may form during at least a portion of the film forming process. Depending upon the film formation method, the composition may be deposited onto a substrate as a fluid. The term "fluid", as used herein, denotes a liquid phase, a gas phase, and combinations thereof (e.g., vapor) of the composition. The term "substrate", as used herein, is any suitable composition that is formed before the film described herein is applied to and/or formed on that composition. Suitable substrates that may be used include, but are not limited to, semiconductor materials such as gallium arsenide ("GaAs"), silicon, and compositions containing silicon such as crystalline silicon, polysilicon, amorphous silicon, epitaxial silicon, silicon dioxide ("$SiO_2$"), silicon glass, silicon nitride, fused silica, glass, quartz, borosilicate glass, and combinations thereof. Other suitable substrates include metals commonly employed in semi-conductor, flat panel display, and flexible display applications.

The film-forming composition may be deposited onto the substrate via a variety of methods including, but not limited to, dipping, rolling, brushing, spraying, extrusion, spin-on deposition, printing, and combinations thereof. Further exemplary deposition methods include oscillating non-contact induced spreading forces, gravity-induced spreading forces, wetting-induced spreading forces, slot extrusion, and combinations thereof.

In one particular embodiment, the deposition of the film-forming composition is conducted using a spin-on deposition method. In brief, the film-forming composition is dispensed onto a substrate and the solvent contained

therein is evaporated to form the coated substrate. Further, centrifugal force is used to ensure that the film-forming composition is uniformly deposited onto the substrate. In these embodiments, the spinning bowl configuration may be a closed, a semi-closed, or an open spinning bowl configuration. In certain embodiments, the solvents disclosed herein are particularly advantageous for use in an open or semi-closed spinning bowl configuration since it may be relatively difficult to change the environment during film formation.

The materials described herein comprise silica. The term "silica", "silica based", or "silica containing", as used herein, is a material that has silicon (Si) and oxygen (O) atoms, and possibly additional substituents such as, but not limited to, other elements such as H, B, C, P, or halide atoms or organic groups such as alkyl groups or aryl groups. In certain preferred embodiments, the material may further comprise silicon-carbon bonds having a total number of Si-C bonds to the total number of Si atoms ranging from between about 20 to about 80 mole percent or from between about 40 to about 60 mole percent.

The composition generally comprises an at least one silica source and a solvent. The composition may further include other constituents such as, but not limited to, water, at least one porogen, a catalyst, a flow additive, and/or ionic additives. In embodiments wherein the composition contains at least one porogen, the weight ratio of porogen to the combined weight of porogen and $SiO_2$, i.e. void fraction, ranges from 0.9 to 0.1. This range may vary depending upon the desired dielectric constant of the material produced from the composition since the dielectric constant of the material is inversely proportional to the weight ratio of the porogen or directly proportional to the void fraction of the composition/film. In the foregoing ratio, the weight of $SiO_2$ is calculated from the total number of moles of silicon introduced by the silica sources within the composition. This, however, does not necessarily imply that the silica sources are completely converted to $SiO_2$. In embodiments wherein the composition contains an ionic additive, the weight ratio of ionic additive to weight of porogen ranges from 0.5 to 0. In further embodiments, the molar ratio of organic constituents or R groups to Si ranges from 0.2 to 3, or from 0.2 to 2, or from 0.2 to 1. In still further embodiments, the molar ratio of water to OR group(s), wherein OR is an organic group bonded to silicon through an oxygen atom, may range from 40 to 0.1..

In certain embodiments, the composition employs chemicals that meet the requirements of the electronics industry because they do not contain contaminants, which reduce the efficiency of preparation of integrated circuits. Constituents like halogen-containing mineral acids, cationic surfactants with halide counter ions, and anionic surfactants with alkali metal counter ions are avoided in the composition because they may contribute undesirable ions. In these embodiments, the compositions described herein contain contaminating metals in amounts of 1 parts per million ("ppm") or less, 200 parts per billion ("ppb") or less, or 50 ppb or less. Consequently, materials of the invention may contain contaminating metals in amounts of 1 ppm or less, 200 ppb or less, or 50 ppb or less. Materials described herein preferably contain contaminating halides in amounts of 1 ppm or less, 750 ppb or less, or 500 ppb or less. The chemical reagents within the composition contain contaminating metals in amounts of 1 ppm or less, 200 ppb or less, or 50 ppb or less. In certain embodiments, if the chemical reagent contains greater than 1 ppm of contaminating metals, the chemical reagent may be purified prior to addition to the composition. Pending U.S. Published Application 2004-0048960, which is incorporated herein by reference and assigned to the assignee of the present application, provides examples of suitable chemicals and methods for purifying same that can be used in the film-forming composition.

As mentioned previously, the composition comprises at least one silica source. A "silica source", as used herein, is a compound having silicon (Si) and oxygen (O) and possibly additional substituents such as, but not limited to, other elements such as H, B, C, P, or halide atoms and organic groups such as alkyl groups; or aryl groups. The term "alkyl" as used herein includes linear, branched, or cyclic alkyl groups, containing from 1 to 24 carbon atoms, or from 1 to 12 carbon atoms, or from 1 to 5 carbon atoms. This term applies also to alkyl moieties contained in other groups such as haloalkyl, alkaryl, or aralkyl. The term "alkyl" further applies to alkyl moieties that are substituted, for example with carbonyl functionality. The term "aryl" as used herein applies to six to twelve member carbon rings having aromatic character. The term "aryl" also applies to aryl moieties that are substituted. The silica source may include materials that have a high number of Si-O bonds, but can further include Si-O-Si bridges, Si-R-Si bridges, Si-C bonds, Si-H bonds, Si-F bonds, or C-H bonds. In certain embodiments, the at least one silica source imparts a minimum of Si-OH bonds in the dielectric material.

The following are non-limiting examples of silica sources suitable for use in the composition described herein. In the chemical formulas which follow and in all chemical formulas throughout this document, the term "independently" should be understood to denote that the subject R group is not only independently selected relative to other R groups bearing different superscripts, but is also independently selected relative to any additional species of the same R group. For example, in the formula $R_aSi(OR^1)_{4-a}Si$, when "a" is 2, the two R groups need not be identical to each other or to $R^1$. In addition, in the following formulas, the term "monovalent organic group" relates to an organic group bonded to an element of interest, such as Si or O, through a single C bond, i.e., Si-C or O-C. Examples of monovalent organic groups include an alkyl group, an aryl group, an unsaturated alkyl group, and/or an unsaturated alkyl group substituted with alkoxy, ester, acid, carbonyl, or alkyl carbonyl functionality. The alkyl group may be a linear, branched, or cyclic

alkyl group having from 1 to 5 carbon atoms such as, for example, a methyl, ethyl, propyl, butyl, or pentyl group. Examples of aryl groups suitable as the monovalent organic group include phenyl, methylphenyl, ethylphenyl and fluorophenyl. In certain embodiments, one or more hydrogen atoms within the alkyl group may be substituted with an additional atom such as a halide atom (i.e., fluorine), or an oxygen atom to give a carbonyl or ether functionality.

In certain embodiments, the silica source may be represented by the following formula: $R_aSi(OR^1)_{4-a}$, wherein R independently represents a hydrogen atom, a fluorine atom, or a monovalent organic group; $R^1$ independently represents a monovalent organic group; and a is an integer ranging from 1 to 2. Specific examples of the compounds represented by $R_aSi(OR^1)_{4-a}$ include: methyltrimethoxysilane, methyltriethoxysilane, methyltri-n-propoxysilane, methyltri-iso- propoxysilane, methyltri-n-butoxysilane, methyltri-sec-butoxysilane, methyltri-tert-butoxysilane, methyltriphenoxysilane, ethyltrimethoxysilane, ethyltriethoxysilane, ethyltri-n-propoxysilane, ethyltri-iso-propoxysilane, ethyltri-n-butoxysilane, ethyltri-sec-butoxysilane, ethyltri-tert-butoxysilane, ethyltriphenoxysilane, n-propyltrimethoxysilane, n-propyltriethoxysilane, n-propyltri-n-propoxysilane, n-propyltri-iso-propoxysilane, n-propyltin-n-butoxysilane, n-propyltri-sec-butoxysilane, n-propyltri-tert-butoxysilane, n-propyltriphenoxysilane, isopropyltrimethoxysilane, isopropyltriethoxysilane, isopropyltri-n-propoxysilane, isopropyltriisopropoxysilane, isopropyltri-n-butoxysilane, isopropyltri-sec-butoxysilane, isopropyltri-tert-butoxysilane, isopropyltriphenoxysilane, n-butyltrimethoxysilane, n-butyltriethoxysilane, n-butyltri-n-propoxysilane, n- butyltriisopropoxysilane, n-butyltri-n-butoxysilane, n-butyltri-sec-butoxysilane, n-butyltri-tert-butoxysilane, n-butyltriphenoxysilane; sec-butyltrimethoxysilane, sec-butyltriethoxysilane, sec-butyltri-n-propoxysilane, sec-butyltriisopropoxysilane, sec-butyltri-n-butoxysilane, sec-butyltri-sec-butoxysilane, sec-butyltri-tert-butoxysilane, sec-butyltriphenoxysilane, tert-butyltrimethoxysilane, tert-butyltriethoxysilane, tert-butyltri-n-propoxysilane, tert-butyltriisopropoxysilane, tert-butyltri-n-butoxysilane, tert-butyltri-sec-butoxysilane, tert-butyltri-tert-butoxysilane, tert-butyltriphenoxysilane, isobutyltrimethoxysilane, isobutyltriethoxysilane, isobutyltri-n-propoxysilane, isobutyltriisopropoxysilane, isobutyltri-n-butoxysilane, isobutyltri-sec-butoxysilane, isobutyltri-tert-butoxysilane, isobutyltriphenoxysilane, n-pentyltrimethoxysilane, n-pentyltriethoxysilane, n-pentyltri-n-propoxysilane, n-pentyltriisopropoxysilane, n-pentyltri-n-butoxysilane, n-pentyltri-sec-butoxysilane, n-pentyltri-tert-butoxysilane, n-pentyltriphenoxysilane; sec-pentyltrimethoxysilane, sec-pentyltriethoxysilane, sec-pentyltri-n-propoxysilane, sec-pentyltriisopropoxysilane, sec-pentyltri-n-butoxysilane, sec-pentyltri-sec-butoxysilane, sec-pentyltri-tert-butoxysilane, sec-pentyltriphenoxysilane, tert-pentyltrimethoxysilane, tert-pentyltriethoxysilane, tert-pentyltri-n-propoxysilane, tert-pentyltriisopropoxysilane, tert-pentyltri-n-butoxysilane, tert-pentyltri-sec-butoxysilane, tert-pentyltri-tert-butoxysilane, tert-pentyltriphenoxysilane, isopentyltrimethoxysilane, isopentyltriethoxysilane, isopentyltri-n-propoxysilane, isopentyltriisopropoxysilane, isopentyltri-n-butoxysilane, isopentyltri-sec-butoxysilane, isopentyltri-tert-butoxysilane, isopentyltriphenoxysilane, neo-pentyltrimethoxysilane, neo-pentyltriethoxysilane, neo-pentyltri-n-propoxysilane, neo-pentyltriisopropoxysilane, neo-pentyltri-n-butoxysilane, neo-pentyltri-sec-butoxysilane, neo-pentyltri-neo-butoxysilane, neopentyltriphenoxysilane phenyltrimethoxysilane, phenyltriethoxysilane, phenyltri-ripropoxysilane, phenyltriisopropoxysilane, phenyltri-n-butoxysilane, phenyltri-sec-butoxysilane, phenyltri-tert-butoxysilane, phenyltriphenoxysilane, δ-trifluoropropyltrimethoxysilane, δ-trifluoropropyltriethoxysilane, dimethyldimethoxysilane, dimethyldiethoxysilane, dimethyldi-n-propoxysilane, dimethyldiisopropoxysilane, dimethyldi-n-butoxysilane, dimethyldi-sec-butoxysilane, dimethyldi-tert-butoxysilane, dimethyldiphenoxysilane, diethyldimethoxysilane, diethyldiethoxysilane, diethyldi-n-propoxysilane, diethyldiisopropoxysilane, diethyldi-n-butoxysilane, diethyldi-sec-butoxysilane, diethyldi-tert-butoxysilane, diethyldiphenoxysilane, di-n-propyldimethoxysilane, di-n-propyldimethoxysilane, di-n-propyldi-n-propoxysilane, di-n-propyldiisopropoxysilane, di-n-propyldi-n-butoxysilane, di-n-propyldi-sec-butoxysilane, din-propyldi-tert-butoxysilane, di-n-propyldiphenoxysilane, diisopropyldimethoxysilane, diisopropyldiethoxysilane, diisopropyldi-n-propoxysilane, diisopropyldiisopropoxysilane, diisopropyldi-n-butoxysilane, diisopropyldi-sec-butoxysilane, diisopropyldi-tert-butoxysilane, diisopropyldiphenoxysilane, di-n-butyldimethoxysilane, di-n-butyldiethoxysilane, di-n-butyldi-n-propoxysilane, di-n-butyldiisopropoxysilane, di-n-butyldi-n-butoxysilane, di-n-butyldi-sec-butoxysilane, di-n-butyldi-tert-butoxysilane, di-n-butyldiphenoxysilane, di-sec-butyldimethoxysilane, di-sec-butyldiethoxysilane, di-sec-butyldi-n-propoxysilane, di-sec-butyldiisopropoxysilane, di-sec-butyldi-n-butoxysilane, di-sec-butyldi-sec-butoxysilane, di-sec-butyldi-tert-butoxysilane, di-sec-butyldiphenoxysilane, di-tert-butyldimethoxysilane, di-tert-butyldiethoxysilane, di-tert-butyldi-n-propoxysilane, di-tert-butyldiisopropoxysilane, di-tert-butyldi-n-butoxysilane, di-tert-butyldi-sec-butoxysilane, di-tert-butyldi-tert-butoxysilane, di-tert-butyldiphenoxysilane, diphenyldimethoxysilane, diphenyldiethoxysilane, diphenyldi-n-propoxysilane, diphenyldiisopropoxysilane, diphenyldi-n-butoxysilane, diphenyldi-sec-butoxysilane, diphenyldi-tert-butoxysilane, diphenyldiphenoxysilane, methylneopentyldimethoxysilane, methylneopentyldiethoxysilane, methyldimethoxysilane, ethyldimethoxysilane, n-propyldimethoxysilane, isopropyldimethoxysilane, n-butyldimethoxysilane, sec-butyldimethoxysilane, tert-butyldimethoxysilane, isobutyldimethoxysilane, n-pentyldimethoxysilane, sec-pentyldimethoxysilane, tert-pentyldimethoxysilane, isopentyldimethoxysilane, neopentyldimethoxysilane, neohexyldimethoxysilane, cyclohexyldimethoxysilane, phenyldimethoxysilane, methyldiethoxysilane, ethyldiethoxysilane, n-propyldiethoxysilane, isopropyldiethoxysilane, n-butyldiethoxysilane, sec-butyldiethoxysilane, tert-butyldiethoxysilane, isobutyldiethoxysilane, n-pentyldiethoxysilane, sec-pentyldiethoxysilane, tert-pentyldiethoxysilane, isopentyldiethoxysilane, neopentyldiethoxysilane, neohexyldiethoxysilane, cyclohexyldiethoxysilane, phenyldiethoxysilane, trimethoxysilane, triethoxysilane, tri-n-propoxysilane, triisopropoxysilane, tri-n-butoxysilane, tri-sec-butoxysilane, tri-tert-butoxysilane, triphenoxysilane, allyltrimethoxysilane, allyltriethoxysilane, vinyltrimethoxsilane, vinyltriethoxysilane, (3-acryloxypropyl)trimethoxysilane, allyltrimethoxysilane, allyltriethoxysilane, vinyltrimethoxsilane, vinyltriethoxysilane, and (3-acryloxypropyl)trimethoxysilane. Of the above compounds, the preferred compounds are methyltrimethoxysilane, methyltriethoxysilane, methyltri-n-propoxysilane, methyltriisopropoxysilane, ethyltrimethoxysilane, ethyltriethoxysilane, dimethyldimethoxysilane, dimethyldiethoxysilane, diethyldimethoxysilane, and diethyldiethoxysilane.

The silica source may be a compound having the formula $Si(OR^2)_4$ wherein $R^2$ independently represents a monovalent organic group. Specific examples of the compounds represented by $Si(OR^2)_4$ include tetramethoxysilane, tetraethoxysilane, tetra-n-propoxysilane, tetraisopropoxysilane, tetra-n-butoxysilane, tetra-sec-butoxysilane, tetra-tert-butoxysilane, tetraacetoxysilane, and tetraphenoxysilane. Of the above, certain preferred compounds may include tetramethoxysilane, tetraethoxysilane, tetra-n-propoxysilane, tetraisopropoxysilane, or tetraphenoxysilane.

The silica source may be a compound having the formula $R^3_b(R^4O)_{3-b}Si-(R^7)-Si(OR^5)_{3-c}R^6_c$, wherein $R^3$ and $R^6$ are independently a hydrogen atom, a fluorine atom, or a monovalent organic group; $R^4$ and $R^5$ are independently a monovalent organic group; b and c may be the same or different and each is a number ranging from 0 to 2; $R^7$ is an oxygen atom, a phenylene group, a biphenyl, a naphthalene group, or a group represented by $-(CH_2)_n-$, wherein n is an integer ranging from 1 to 6; or combinations thereof. Specific examples of these compounds wherein $R^7$ is an oxygen atom include: hexamethoxydisiloxane, hexaethoxydisiloxane, hexaphenoxydisiloxane, 1,1,1,3,3-pentamethoxy-3-methyldisiloxane, 1,1,1,3,3-pentaethoxy-3-methyldisiloxane, 1,1,1,3,3-pentamethoxy-3-phenyldisiloxane, 1,1,1,3,3-pentaethoxy-3-phenyldisiloxane, 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,1,3,3-tetraethoxy-1,3-diphenyldisiloxane, 1,1,3-trimethoxy-1,3,3-trimethyldisiloxane, 1,1,3-triethoxy-1,3,3-trimethyldisiloxane, 1,1,3-trimethoxy-1,3,3-triphenyldisiloxane, 1,1,3-triethoxy-1,3,3-triphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane and 1,3-diethoxy-1,1,3,3-tetraphenyldisiloxane. Of those, preferred compounds are hexamethoxydisiloxane, hexaethoxydisiloxane, hexaphenoxydisiloxane, 1,1,3,3-tetramethoxy-1,3-dimethyldisiloxane, 1,1,3,3-tetraethoxy-1,3-dimethyldisiloxane, 1,1,3,3-tetramethoxy-1,3-diphenyldisiloxane, 1,3-dimethoxy-1,1,3,3-tetramethyldisiloxane, 1,3-diethoxy-1,1,3,3-tetramethyldisiloxane, 1,3-dimethoxy-1,1,3,3-tetraphenyldisiloxane;1,3-diethoxy-1,1,3,3-tetraphenyldisiloxane. Specific examples of these compounds wherein $R^7$ is a group represented by $-(CH_2)_n-$ include: bis(trimethoxysilyl)methane, bis(triethoxysilyl)methane, bis(triphenoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethylsilyl) methane, bis(methoxydiphenylsilyl)methane, bis(ethoxydiphenylsilyl)methane, 1,2-bis(trimethoxysilyl)ethane, 1,2-bis (triethoxysilyl)ethane, 1,2-bis(triphenoxysilyl)ethane, 1,2-bis(dimethoxymethylsilyl)ethane, 1,2-bis(diethoxymethylsilyl)ethane, 1,2-bis(dimethoxyphenylsilyl)ethane, 1,2-bis(diethoxyphenylsilyl)ethane, 1,2-bis(methoxydimethylsilyl) ethane, 1,2-bis(ethoxydimethylsilyl)ethane, 1,2-bis(methoxydiphenylsilyl)ethane, 1,2-bis(ethoxydiphenylsilyl)ethane, 1,3-bis(trimethoxysilyl)propane, 1,3-bis(triethoxysilyl)propane, 1,3-bis(triphenoxysilyl)propane, 1,3-bis(dimethoxymethylsilyl)propane, 1,3-bis(diethoxymethylsilyl)propane, 1,3-bis(dimethoxyphenylsilyl)propane, 1,3-bis(diethoxyphenylsilyl)propane, 1,3-bis(methoxydimethylsilyl)propane, 1,3-bis(ethoxydimethylsilyl)propane, 1,3-bis(methoxydiphenylsilyl)propane, and 1,3-bis(ethoxydiphenylsilyl) propane. Of those, preferred compounds are bis(trimethoxysilyl)methane, bis(triethoxysilyl)methane, bis(dimethoxymethylsilyl)methane, bis(diethoxymethylsilyl)methane, bis (dimethoxyphenylsilyl)methane, bis(diethoxyphenylsilyl)methane, bis(methoxydimethylsilyl)methane, bis(ethoxydimethylsilyl)methane, bis(methoxydiphenylsilyl)methane and bis(ethoxydiphenylsilyl)methane.

In certain embodiments of the present invention, $R^1$ of the formula $R_aSi(OR^1)_{4-a}$; $R^2$ of the formula $Si(OR^2)_4$; and $R^4$ and/or $R^5$ of the formula $R^3_b(R^4O)_{3-b}Si-(R^7)-Si(OR^5)_{3-c}R^6c$ can each independently be a monovalent organic group of the formula:

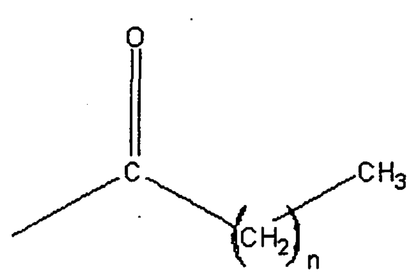

wherein n is an integer ranging from 0 to 4. Specific examples of these compounds include: tetraacetoxysilane, methyltriacetoxysilane, ethyltriacetoxysilane, n-propyltriacetoxysilane, isopropyltriacetoxysilane, n-butyltriacetoxysilane, sec-butyltriacetoxysilane, tert-butyltriacetoxysilane, isobutyltriacetoxysilane, n-pentyltriacetoxysilane, sec-pentyltriacetoxysilane, tert-pentyltriacetoxysilane, isopentyltriacetoxysilane, neopentyltriacetoxysilane, phenyltriacetoxysilane, dimethyldiacetoxysilane, diethyldiacetoxysilane, di-n-propyldiacetoxysilane, diisopropyldiacetoxysilane, di-n-butyldiacetoxysilane, di-sec-butyldiacetoxysilane, di-tert-butyldiacetoxysilane, diphenyldiacetoxysilane, triacetoxysilane. Of these compounds, tetraacetoxysilane and methyltriacetoxysilane are preferred.

Other examples of the at least one silica source may include a fluorinated silane or fluorinated siloxane such as those provided in U. S. Pat. No. 6,258,407.

Another example of at least one silica source may include compounds that produce a Si-H bond upon elimination.

Still further examples of the at least one silica source are found in the non-hydrolytic chemistry methods described, for example, in the references Hay et al., "Synthesis of Organic-Inorganic Hybrids via the Non-hydrolytic Sol-Gel Process", Chem. Mater., 13, 3396-3403 (2001) or Hay, et al., "A Versatile Route to Organically-Modified Silicas and Porous Silicas via the Non-Hydrolytic Sol-Gel Process", J. Mater. Chem., 10, 1811-1818 (2000).

Still other examples of silica sources include silsesquioxanes such as hydrogen silsesquioxanes (HSQ, $HSiO_{1.5}$) and methyl silsesquioxanes (MSQ, $RSiO_{1.5}$ where R is a methyl group).

In certain embodiments, the at least one silica source may preferably have an at least one carboxylic acid ester bonded to the Si atom. Examples of these silica sources include tetraacetoxysilane, methyltriacetoxysilane, ethyltriacetoxysilane, and phenyltriacetoxysilane. In addition to the at least one silica source wherein the silica source has at least one Si atom having an carboxylate group attached thereto, the composition may further comprise additional silica sources that may not necessarily have the carboxylate attached to the Si atom.

In some embodiments, a combination of hydrophilic and hydrophobic silica sources is used in the composition. The term "hydrophilic", as used herein, refers to compounds wherein the silicon atom can crosslink through at least four bonds. In these embodiments, the ratio of hydrophobic silica source to the total amount of silica source is greater than about 0.2 molar ratio or from 0.2 to 0.8 molar ratio. Some examples of hydrophilic sources include alkoxysilanes having an alkoxy functionality and can at least partially crosslink, i.e., a Si atom with four methoxy, ethoxy, propoxy, acetoxy, etc. groups, or materials with carbon or oxygen bonds between Si atoms and all other functionality on the Si atoms being an alkoxide. If the Si atoms do not fully crosslink, residual Si-OH groups may be present as terminal groups that can adsorb water. The term "hydrophobic" refers to compounds where at least one of the alkoxy functionalities has been replaced with a terminal Si-C or Si-F bond, i.e. Si-methyl, Si-ethyl, Si-phenyl, Si-cyclohexyl, etc., that would not generate a hydroxyl after hydrolysis. In these sources, the silicon would crosslink with less than four bridges even when fully crosslinked as a result of hydrolysis and condensation of Si-OH groups if the terminal group remains intact. In certain embodiments, the hydrophobic silica source contains a methyl group attached to the silicon atom.

The at least one silica source may be added to the composition as the product of hydrolysis and condensation. Hydrolysis and condensation of the silica source occurs by adding water and optionally a catalyst to a solvent and adding the silica source at a time, intermittently or continuously, and conducting hydrolysis and condensation reactions at a temperature range generally from -30 to 100°C or from 20 to 100°C. Upon contact with water and the optional catalyst, at least a portion of the at least one silica source hydrolyzes and condenses. A by-product of hydrolysis and condensation reaction is the formation of a low boiling solvent. The term "low boiling solvent" as used herein is a solvent -other than water- that boils at a temperature below 90°C.

The hydrolysis and condensation of the silica source can occur at any point during the formation of the film, i.e., before adding to the composition, after adding to the composition, prior to deposition, and/or during curing, etc. For example, the at least one silica source may be combined with the solvent, water, and surfactant in a first vessel, the optional ionic additive and optional catalyst are combined in a second vessel, and the contents of the second vessel are gradually added to the first vessel and mixed. It is envisioned that a variety of different orders of addition to the composition can be used.

The composition may include a carboxylate. In these embodiments, the carboxylate that is added to the composition may be selected from the group consisting of carboxylic acid, a carboxylate anion, a carboxylic acid ester, or combinations thereof. Examples of carboxylic acids include formic, acetic, propionic, maleic, oxalic, glycolic, glyoxalic, or mixtures thereof. Examples of carboxylic acid ester compounds include ethyl acetate, acetic anhydride, and ethoxylated fatty acids. The carboxylate compound may be added as a separate ingredient, be formed within the composition upon the dissolution of the chemical reagent within the composition; and/or be part of at least one silica source wherein at least one carboxylic acid ester is bonded to the Si atom, such as tetraacetoxysilane, methyltriacetoxysilane, etc. The carboxylic acid esters may react in the presence of water and/or catalyst to generate carboxylic acid. In some instances, the carboxylate compound may act as the catalyst within the composition for the hydrolysis and condensation of the at least one silica source.

In embodiments wherein a catalyst is added, the catalyst may include any organic or inorganic acid or base that can catalyze the hydrolysis of substitutents from the silica source in the presence of water, and/or the condensation of two silica sources to form an Si-O-Si bridge. The catalyst can be an organic base such as, but not limited to, quaternary ammonium salts and hydroxides, such as ammonium or tetramethylammonium, amines such as primary, secondary, and tertiary amines, or amine oxides. The catalyst can also be an acid such as, but not limited to, nitric acid, maleic, oxalic, acetic, formic, glycolic, glyoxalic acid, or mixtures thereof. In certain embodiments, the catalyst comprises a non-halide containing acid, such as nitric acid.

The film forming composition and methods disclosed herein include a solvent or mixture thereof. The term "solvent" as used herein refers to any liquid or supercritical fluid that provides at least one of the following: solubility with the reagents, the amount of which that is capable of adjusting the film thickness, provides sufficient optical clarity for subsequent processing steps such as, for example, lithography, and/or may be substantially removed upon curing. Exemplary at least one solvents useful for the film-forming composition can be alcohol solvents, ketone solvents, amide solvents, or ester solvents. The solvents could also have hydroxyl, carbonyl, and/or ester functionality. In certain embodiments, the solvent has one or more hydroxyl or ester functionalities such as those solvents having the following formulas: $HO-CHR^8-CHR^9-CH_2-CHR^{10}R^{11}$ where $R^8$, $R^9$, $R^{10}$ and $R^{11}$ can independently be an alkyl group ranging from 1 to 4 carbon atoms or a hydrogen atom; and $R^{12}-CO-R^{13}$ where $R^{12}$ is a hydrocarbon group having from 3 to 6 carbon atoms; $R^{13}$ is a hydrocarbon group having from 1 to 3 carbon atoms; and mixtures thereof. Further exemplary solvents include alcohol isomers having from 4 to 6 carbon atoms, ketone isomers having from 4 to 8 carbon atoms, linear or branched hydrocarbon acetates where the hydrocarbon has from 4 to 6 carbon atoms, ethylene or propylene glycol ethers, ethylene or propylene glycol ether acetates. Other solvents that can be used include, 1-pentanol, 2-pentanol, 2-methyl-1-butanol, 2-methyl-1-pentanol, 2-ethoxyethanol, 2-propxoyethanol, 1-propoxy-2-propanol, 2-methoxyethanol, 1-methoxy-2-propanol, 2-heptanone, 4-heptanone, 1-tert-butoxy-2-ethoxyethane, 2-methoxyethylacetate, propylene glycol methyl ether acetate, pentyl acetate, 1-tert-butoxy-2-propanol, 2,3-dimethyl-3-pentanol, 1-methoxy-2-butanol, 4-methyl-2-pentanol, 1-tert-butoxy-2-methoxyethane, 3-methyl-1-butanol, 2-methyl-1-butanol, 3-methyl-2-pentanol, 1,2-diethoxyethane, 1-butanol, 3-methyl-2-butanol, 5-methyl-2-hexanol. Still further exemplary solvents include lactates, pyruvates, and diols. The solvents enumerated above may be used alone or in combination of two or more solvents.

Solvents that are suitable in the film-forming compositions described herein may include any solvent that, for example,'exhibits solubility with the reagents, affects the viscosity of the composition, and/or affects the surface tension of the composition upon deposition onto the substrate. Table I provides a list of exemplary solvents and various properties associated therewith. Some, if not all, of these properties may be important to control to insure that the composition is, for example, homogeneous, dispense volumes are minimized, the film covers the entire substrate, there are no defects in the film, and/or that the film adheres to the substrate or other films that are present in the device.

Table I:

| Exemplary Solvents | | | | | | | |
|---|---|---|---|---|---|---|---|
| Solvent | Molecular Weight | Boiling Point (°C) | Flash point (°F) | Surface Tension (dyne/ cm_ | Viscosity (centipoise) | Density (g/ cc) | Total Solubility Parameter (($J/m^3$) ½) |
| 4-methyl-1-pentanol | 102.18 | 163 | 125 | 22.6 | 4.1 | 0.821 | 19.3 |
| 2-propoxy ethanol | 104.15 | 151 | 120 | 27.3 | 2.7 | 0.913 | 20.8 |
| 1-propoxy-2-propanol (PGPE) | 118.18 | 150 | 119 | 25.4 | 2.4 | 0.885 | 19.9 |
| 5-methyl-2-hexanol | 116.2 | 149 | 115 | 25.1 | 5.9 | 0.819 | 20.2 |
| 2-methyl-1-pentanol | 102.18 | 148 | 123 | 24.9 | 5.5 | 0.824 | 20.8 |
| propylene glycol methyl ether acetate | 132.16 | 145 | 110 | 28.9 | 1.1 | 0.968 | 18.4 |
| 1-pentanol | 88.15 | 137 | 120 | 25.6 | 3.6 | 0.811 | 21.6 |

The boiling point of the solvent may be related to the evaporation rate. For example, across 200 and 300 mm wafer substrates, the evaporation rate of the solvent should be tightly controlled. In this connection, if the boiling point is too high the solvent evaporates slowly and the film does not dry properly whereas if the boiling point is too low there is a high striation density in the resultant film. For embodiments wherein the spin-on deposition is conducted in open or semi-closed spinning bowl configurations, the solvent in the film-forming composition boils at a temperature ranging from about 90 to about 170°C or from about 120 to about 170°C.

In certain embodiments, the surface tension and viscosity of the solvent may be important to provide continuous films without edge effects, e.g., pull back, beading, and ensure that the liquid will flow smoothly across the wafer during the dispense and initial leveling periods of the spinning process. In these embodiments, the viscosity of the composition might exhibit Newtonian behavior, i.e., exhibit substantially no thickening or thinning while under shear conditions so that the film spreads across the substrate uniformly. The combination of the surface tension and viscosity are important in order to spin coat uniform films with no optical defects. In these embodiments, the surface tension of the at least one solvent may range from 20 to 50 dynes/cm measured by the Wilhelmy plate method. Further, the viscosity of the at least one solvent may range from 0.5 to 7 centipoise as measured by the parallel plate method.

In other embodiments, the total solubility parameter of the at least one solvent may be important to provide a film-forming composition having no visible precipitates and/or phase separations. The total solubility parameter for solvents may be described by the following equation: $\delta_t 2 = \delta_d^2 + \delta_p^2 + \delta_h^2$ where $\delta_d^2$ is the component related to the dispersion forces, $\delta_p^2$ is the component related to the polar forces, and $\delta_h^2$ is the component related to the hydrogen bonding forces. In these embodiments, the total solubility parameter may range from 15 to 25 $(J/m^3)^{1/2}$. The total solubility parameter may account for the solubility of water and low boiling point solvents resulting from the hydrolysis and condensation of the silicates, the growing organosilicate polymer, and/or the porogens contained within the composition. If the solvent is not capable of solubilizing all of these components within the film-forming composition then precipitates or phase separations may occur and the films formed therefrom may contain striations, holes, and particles.

In certain embodiments, it may be preferred that the solvent provides at least one of the following benefits: avoids swelling of the pores, which may potentially cause poor barrier and capping properties of other films in the IC stack; produces uniform films, in terms of thickness and composition; aides in wetting substrates or other films, does not adversely affect the adhesion of the film to other films used in the integrated circuit such as, for example, silicon oxides, carbon doped silicon oxides, silicon carbides, silicon oxycarbides, silicon nitrides, silicon oxynitrides, tantalum oxides, tantalum nitrides, tantalum oxynitrides, titanium oxides, titanium nitrides, titanium oxynitrides, aluminum, and copper; and/or avoids introducing impurities or functionalities that could neutralize the acidic portions of photoresists which will reduce their activity, i.e. poison the photoresist.

In certain embodiments, the composition can further comprise at least one porogen. A "porogen", as used herein, is a reagent that is used to generate void volume within the resultant film. Suitable porogens for include labile organic groups, solvents, decomposable polymers, surfactants, dendrimers, hyper-branched polymers, polyoxyalkylene compounds, organic macromolecules, or combinations thereof.

In certain embodiments of the present invention, the porogen may include labile organic groups. When some labile organic groups are present in the composition, the labile organic groups may contain sufficient oxygen to convert to gaseous products during the cure step. Some examples of compounds containing labile organic groups include the compounds disclosed in U. S. Pat. No. 6,171,945, which is incorporated herein by reference in its entirety.

In some embodiments of the present invention, the at least one porogen may be a high boiling point solvent. In this connection, the solvent is generally present during at least a portion of the cross-linking of the matrix material. Solvents typically used to aid in pore formation have relatively higher boiling points, i.e., greater than 170°C or greater than 200°C. High boiling point solvents suitable for use as a porogen within the composition of the present invention include those solvents provided, for example, in U. S. Pat. No. 6,231,989.

In certain embodiments, the at least one porogen may be a small molecule such as those described in the reference Zheng, et al., "Synthesis of Mesoporous Silica Materials with Hydroxyacetic Acid Derivatives as Templates via a Sol-Gel Process", J. Inorg. Organomet. Polymers, 10, 103-113 (2000) or quarternary ammonium salts such as tetrabutylammonium nitrate.

The at least one porogen could also be a decomposable polymer. The decomposable polymer may be radiation decomposable, or more preferably, thermally decomposable. The term "polymer", as used herein, also encompasses the terms oligomers and/or copolymers unless expressly stated to the contrary. Radiation decomposable polymers are polymers that decompose upon exposure to radiation, e.g., ultraviolet, X-ray, electron beam, or the like. Thermally decomposable polymers undergo thermal decomposition at temperatures that approach the condensation temperature of the silica source materials and are present during at least a portion of the cross-linking. Such polymers are those that may foster templating of the vitrification reaction, may control and define pore size, and/or may decompose and diffuse out of the matrix at the appropriate time in processing. Examples of these polymers include, but not limited to, block copolymers, i.e., diblock, triblock, and multiblock copolymers; star block copolymers; radial diblock copolymers; graft diblock copolymers; cografted copolymers; dendrigraft copolymers; tapered block copolymers; and

combinations of these architectures. Further examples of degradable polymers are found in U. S. Pat. No. 6,204,202, which is incorporated herein by reference in its entirety.

The at least one porogen may be a hyper branched or dendrimeric polymer. Hyper branched and dendrimeric polymers generally have low solution and melt viscosities, high chemical reactivity due to surface functionality, and enhanced solubility even at higher molecular weights. Some non-limiting examples of suitable decomposable hyper-branched polymers and dendrimers are provided in "Comprehensive Polymer Science", 2nd Supplement, Aggarwal, pp. 71-132 (1996) that is incorporated herein by reference in its entirety.

The at least one porogen within the film-forming composition may also be a polyoxyalkylene compound such as polyoxyalkylene non-ionic surfactants, polyoxyalkylene polymers, polyoxyalkylene copolymers, polyoxyalkylene oligomers, or combinations thereof. An example of such is a polyalkylene oxide that includes an alkyl moiety ranging from $C_2$ to $C_6$ such as polyethylene oxide, polypropylene oxide, and copolymers thereof.

The at least one porogen could also comprise a surfactant. For silica based films in which the porosity is introduced by the addition of surfactant that is subsequently removed, varying the amount of surfactant can vary porosity. Typical surfactants exhibit an amphiphilic nature, meaning that they can be both hydrophilic and hydrophobic at the same time. Amphiphilic surfactants possess a hydrophilic head group or groups, which have a strong affinity for water and a long hydrophobic tail that is organophilic and repels water. The surfactants can be anionic, cationic, non-ionic, or amphoteric. Further classifications of surfactants include silicone surfactants, poly(alkylene oxide) surfactants, and fluorochemical surfactants. However, for the formation of dielectric layers for IC applications, non-ionic surfactants are generally preferred. Suitable surfactants for use in the composition include, but are not limited to, octyl and nonyl phenol ethoxylates such as TRITON® X-114, X-102, X-45, X-15; alcohol ethoxylates such as BRIJ® 56 ($C_{16}H_{33}(OCH_2CH_2)_{10}OH$) (ICI), BRIJ® 58 ($C_{16}H_{33}(OCH_2CH_2)_{20}OH$) (ICI), and acetylenics diols such as SURFYNOLS® 465 and 485 (Air Products and Chemicals, Inc.). Further surfactants include polymeric compounds such as the tri-block EO-PO-EO co-polymers PLURONIC® L121, L123, L31, L81, L101 and P123 (BASF, Inc.). Still further exemplary surfactants include alcohol (primary and secondary) ethoxylates, amine ethoxylates, glucosides, glucamides, polyethylene glycols, poly(ethylene glycol-co-propylene glycol), or other surfactants provided in the reference *McCutcheon's Emulsifiers and Detergents*, North American Edition for the Year 2000 published by Manufacturers Confectioners Publishing Co. of Glen Rock, N.J.

As mentioned previously, it is preferred that the composition has a metal content below 1 ppm. To ensure that the composition has a metal content below 1 ppm, it is preferred that each chemical reagent has a metal content below 1 ppm. While commercially available unpurified surfactants could be used, the final films may have impurity levels far in excess of acceptable levels, and thus the surfactant should be purified. These unpurified surfactants may commonly possess alkali ion concentrations in the range from about 100 to 1000 parts per million. Some solvents may also have metal impurity levels far in excess of acceptable levels. The goal of chemical reagent purification is to reduce alkali ion impurity levels to less than 50 parts per billion.

In addition to the aforementioned ingredients, the film-forming composition may further comprise an ionic additive. Ionic additives can be added to composition, for example, if the metal impurity content is about 500 ppm or less. Generally, the ionic additive is a compound chosen from a group of cationic additives of the general composition $[(NR_4)^+]_nA^{n-}$, where R can be a hydrogen atom or a monovalent organic group containing 1 to 24 carbon atoms, or compositions of hydrogen atoms and/or monovalent organic groups, including tetramethylammonium and cetyltrimethylammonium, and $A^{n-}$ is an anion where n is the valence of the anion. Preferably, $A^{n-}$ may be chosen from the group consisting of formate, nitrate, oxalate, acetate, phosphate, carbonate, and hydroxide and combinations thereof. Tetramethylammonium salts, or more generally tetraalkylammonium salts, or tetraorganoammonium salts or organoamines in acidic media are added to surfactant templated porous oxide precursor formulations to increase the ionic content, replacing alkali ion impurities (sodium and potassium) removed during porogen purification. The amount of the ionic additive that is added to the composition ranges from 0.1 to 5000 ppm, preferably from 0.1 to 1000 ppm, and more preferably from 0.1 to 250 ppm.

Alternatively, the ionic additive may be an amine or an amine oxide additive which forms an ionic ammonium type salt in the acidic precursor composition. The suitable amine additive is selected from the group consisting of: triethylenediamine (TEDA); diethanolamine (DELA); triethanolamine, (TELA); aminopropyldiethanolamine (APDEA); bis(p-aminocyclohexyl)methane (PACM); quinuclidine (QUIN); 3-Quinuclidinol; trimethylamine (TMA); tetramethylethylendiamine, (TMEDA); tetramethyl-1,3-propanediamine (TMPDA); trimethylamine oxide (TMAO); PC-9, N,N,N-tris(N',N'-dimethyl-3-aminopropyl)amine; PC-77, 3,3'-bis(dimethylamino)-N-methyldipropylamine; CB, choline hydroxide; DMAP, 4-dimethylaminopyridine; DPA, diphenylamine; or TEPA, tetraethylenepentamine.

In certain embodiments, the composition may comprise one or more flow additives to change the surface tension, viscosity, and/or solution slip characteristics of the composition when compared to the composition without the addition of the flow additive. A "flow additive" as used herein means a component of the film forming composition, other than a silica source, solvent, water, porogen, catalyst, or ionic additive, which may change the surface tension of the composition if compared to the surface tension of a comparable composition without the flow additive. In these

embodiments, flow additives may be used, for example, to prevent numerous defects such as non-optimal substrate wetting, crater formation, Benard cell formation, flooding, non-optimal flow, and/or air-draft sensitivity. Many of these defects are created by surface tension differentials, substrate surface roughness, film thickness, rheological behavior after application (changes in viscosity, surface tension during gellation), speed of solvent evaporation, temperature gradients, and concentration gradients. The defects described may be introduced or propagate when there are two or more solvents within the composition that can cause instabilities in the film formation. The flow additive within the composition typically does not evaporate quickly, i.e. the flow additive should be present during the dispense, spreading, leveling, and drying portions of the spin process, decompose at low temperatures, and/or leaves no carbonaceous residues. The use of a small amount of these flow additives may slightly reduce the surface tension of the formulation allowing for better surface wetting, may reduce cratering from overspray during the dispense, and/or may make the film less susceptible to external influences, e.g. dust, humidity, or the film itself as it crosslinks or solidifies. Exemplary flow additives may include, but are not limited to, compounds having fluorinated groups such as perfluorinated alkyls; silicones and polydimethylsiloxanes, such as polyether modified polydimethylsiloxanes; commercially available flow additives, such as BYKCHEMIE™ 307, 331, and 333; silicones; polyacrylates; and paraffinic distillates. In certain embodiments such as when the additive BYKCHEMIE™ 307, the addition of the flow additive may result in a from 0.001 to 50% reduction, or a 0.001 to 20%, or a 0.001 to 15% reduction in surface tension.

In certain embodiments, there is provided a method for improving the ambient storage stability of the composition. It is desirable that the composition exhibit a high degree of reproducibility, particularly thickness, composition, and dielectric constant, when processed into a film. The storage stability of the formulation may be influenced by the film properties, i.e. dielectric constant, film thickness, and modulus, as a function of storage time at ambient conditions. Stability relates to less than 3 % or less than 1.5 % change in thickness and less than 2% or less than 1 % change in dielectric constant from the initial value without any change in the film appearance, i.e. striations, holes, or dewetting. In one embodiment, the storage stability of the film-forming composition, comprising an at least one silica source, a solvent, an at least one porogen, a catalyst, and optionally a flow additive, may be improved by pre-hydrolyzing the at least one silica source with an acid catalyst at a temperature ranging from 30 to 100°C. As mentioned previously, a by-product of the hydrolysis and condensation of the silica source is a low boiling solvent. Once the silicate has been partially polymerized, the low boiling solvent by-product, any separately added low boiling solvent, and/or water are removed to a certain level to provide a reduced composition. In certain embodiments, from about 20 to about 75 % of the total number of moles of low boiling solvents and from 20 to 80% of the total number of moles of water is removed from the initial composition to provide the reduced composition. This reduced composition results in an increase of ambient storage stability of the composition to 10 days or greater. The low boiling solvent and/or water can be removed, for example, by vacuum distillation, flash evaporation using a rotary evaporator or other means. In other embodiments, the water and low boiling solvents can be removed by heating under vacuum at a temperature ranging from 25 to 100°C. Once the water and low boiling point solvents have been removed from the composition, a solvent that boils at a temperature greater than 90°C such as any of the solvents disclosed herein, can be added to the reduced composition to control the thickness and overall composition properties.

In certain embodiments, the radius of gyration of the hydrolyzed and condensed silicate species in the film forming composition ranges from 5 nm or less or from 3 nm or less as determined by low mass gel permeation chromatography coupled with on-line differential viscometry detection. When the radius of gyration of the hydrolyzed and condensed silicate is 5 nm or less and the water and low boiling point solvents have been removed, the composition is able to be stored under ambient conditions for extended periods of time. This composition previously described produces films with excellent uniformity, dielectric constant, modulus, and adhesion to films in the IC stack and silicon substrates.

In embodiments where the film is formed through a spin-on approach, the composition comprises, *inter alia,* at least one silica source and a solvent. The composition may further comprise at least one porogen, an optional catalyst, an optional ionic additive, and water. In certain embodiments, the composition further comprises a flow additive. In brief, dispensing the composition onto a substrate and evaporating the solvent and water can form the films. The porogen, remaining solvent, and water are generally removed by curing the coated substrate to one or more temperatures and for a time sufficient to produce the low dielectric film.

The composition may be deposited onto the substrate to form the coated substrate. In certain embodiments, the composition is deposited using a spin-on deposition method using an open or a semi-closed spinning bowl configuration. As described earlier, the properties, evaporation rate, boiling point, surface tension, and viscosity, of the solvent within the composition are important to prepare highly uniform defect-free films when the degree of solvent saturation and moisture content of the atmosphere above the substrate is provided by the surrounding environment, usually 45% relative humidity and ambient temperature. In certain embodiments, the film-forming compositions comprising one or more solvents that boil at a temperature ranging from 90 to 170°C or from 120 to 170°C, a surface tension ranging from a 20 to 50 dyne/cm, a viscosity ranging from 0.5 to 7 cP, and a total solubility parameter ranging from 15 to 25 $(J/m^3)^{1/2}$. The composition could further comprise a catalyst, at least one porogen, ionic additive, and/or a flow additive.

To reduce the amount of material that is dispensed onto the substrate, the properties of the film forming composition comprising a silica source, solvent and optional flow additive should be adequate to completely cover the entire surface area without introducing any defects at the wafer edges, e.g., cracking, delamination, peeling, and/or film retraction. The deposition is conducted using a continuous stream of a liquid-based composition. Reduction in the dispensed amount of film forming composition is important to control the cost of ownership of the tool, reduce waste, and minimize the amount of material that is required to be removed from the side of the bowl using a bowl rinse solvent. Important solvent properties include boiling at a temperature ranging from 90 to 170°C, surface tension ranging from 20 to 50 dyne/cm, viscosity ranging from 0.5 to 7 cP, and a total solubility parameter ranging from 15 to 25 $(J/m^3)^{1/2}$. A composition has Newtonian behavior under shear may aid in reducing the dispense volume of the film forming composition. The composition could further comprise a catalyst, porogen, and ionic additive. Additional ways to reduce the amount of film forming composition to prepare uniform films include extrusion, and spray deposition techniques.

The coated substrate may be heated or cured to form the dielectric film. Specific temperature and time durations will vary depending upon the ingredients within the composition, the substrate, and the desired pore volume. In certain embodiments, the cure step is conducted at two or more temperatures rather than a controlled ramp or soak. The first temperature, typically below 300°C, may be to remove the water and/or solvent from the composition and to further cross-linking reactions. The second temperature may be to remove the porogen and to substantially, but not necessarily completely, cross-link the material. In certain preferred embodiments of the present invention, the coated substrate is heated to one or more temperatures ranging from about 250 to about 450°C, or more preferably about 400°C or below. The heating or cure step is conducted for a time of about 30 minutes or less, or about 15 minutes or less, or about 6 minutes or less. The silica source may further include residual components from processing, such as organics that were not removed after formation of the porous material.

The cure step is preferably conducted via thermal methods such as a hot plate, oven, fumace or the like. For thermal methods, the curing of the coated substrate may be conducted under controlled conditions such as atmospheric pressure using nitrogen, inert gas, air, or other $N_2/O_2$ mixtures (0-21% $O_2$), vacuum, or under reduced pressure having controlled oxygen concentration. Alternatively, the cure step may be conducted by electron-beam, ozone, plasma, X-ray, ultraviolet radiation or other means. Cure conditions such as time, temperature, and atmosphere may vary depending upon the method selected. In preferred embodiments, the curing step is conducted via a thermal method in an air, nitrogen, or inert gas atmosphere, under vacuum, or under reduced pressure having an oxygen concentration of 10% or lower.

The materials and films described herein may be further subjected to post cure steps such as a post-cure e-beam, UV, X-ray or other treatments. Unlike chemical post treatments such as those described in U.S. Pat. No. 6,329,017, these treatments may, for example, increase the mechanical integrity of the material or decrease the dielectric constant by reducing hydroxyl groups that in turn reduce sites likely to adsorb water.

The materials and films described herein may be mesoporous. The term "mesoporous", as used herein, describes pore sizes that range from about 10 Å to about 500 Å, or from about 10 Å to about 100 Å, or from about 10 Å to about 50 Å. It is preferred that the film have pores of a narrow size range and that the pores are homogeneously distributed throughout the film. Certain films may have a porosity ranging from about 10% to about 90%. The porosity of the films may be closed or open pore.

In certain embodiments of the present invention, the diffraction pattern of the film does not exhibit diffraction peaks at a d-spacing greater than 10 Angstroms. The diffraction pattern of the film may be obtained in a variety of ways such as, but not limited to, neutron, X-ray, small angle, grazing incidence, and reflectivity analytical techniques. For example, conventional x-ray diffraction data may be collected on a sample film using a conventional diffractometer such as a Siemens D5000 $\theta$-$\theta$ diffractometer using CuK$\alpha$ radiation. Sample films may also be analyzed by X-ray reflectivity (XRR) data using, for example, a Rigaku ATX-G high-resolution diffraction system with Cu radiation from a rotating anode x-ray tube. Sample films may also be analyzed via small-angle neutron scattering (SANS) using, for example, a system such as the 30 meter NG7 SANS instrument at the NIST Center for Neutron Research. In alternative embodiments, the diffraction pattern of the film does exhibit diffraction peaks at a d-spacing greater than 10 Angstroms..

The materials described herein exhibit mechanical properties that allow the material, when formed into a film, to resist cracking and enable it to be chemically/mechanically planarized. Further, the films exhibit low shrinkage. Films generally have a thickness that ranges from 0.05 to about 2 $\mu$m. Films may exhibit a modulus of elasticity that ranges from about 0.5 to about 10 GPa, and generally between 1.2 and 6 GPa; a hardness value that ranges from about 0.1 to about 2.0 GPa, and generally from about 0.4 to about 1.2 GPa, and a refractive index determined at 633 nm of between 1.1 and 1.5. The dielectric constant is about 3.7 or less.

As mentioned previously, the films and materials described herein are suitable for use in electronic devices. The films provides excellent insulating properties and a relatively high modulus of elasticity. The film also provides advantageous film uniformity, dielectric constant stability, cracking resistance, adhesion to the underlying substrate and/or other films, controlled pore size and/or nanopore size, and surface hardness. Film uniformity which is commonly as percent standard deviation is defined herein as the standard deviation divided by the average film thickness multiplied by 100% for the substrate for the being measured. In certain embodiments, the film uniformity is 5% or less or 2% or less, wherein it denotes % standard deviation. Suitable applications for the film of the present invention include interlayer insulating films for semiconductor devices such as large scale integration (LSI), system LSIs, dynamic random access memory (DRAM), static dynamic random access memory (SDRAM), RDRAMs, and D-RDRAMs protective films such as surface coat films for semiconductor devices, interlayer insulating films for multilayered printed circuit boards, and protective or insulating films for liquid-crystal display devices. Further applications include photonics, nano-scale mechanical or nano-scale electrical devices, gas separations, liquid separations, or chemical sensors.

EXAMPLES

In the following examples, unless stated otherwise, properties were obtained from sample films that were spun onto a low resistance (0.01 Ωcm) single crystal silicon wafer substrate and heated to 400°C. The thickness, film refractive index, and porosity values of each film were determined by spectroscopic ellipsometry using a variable angle spectroscopic ellipsometer, Model SE 800 manufactured by Sentech Instruments GmbH, and calculated by SpectraRay software. The refractive index, film thickness, and percentage of air values were obtained by simulating the measurement using various models such as Bruggemann in the wavelength range from 400 to 800 nm with mean square error of about 1 or less. For the thickness values, the error between the simulated thickness and actual film thickness values measured by profilometry was generally less than 2%. Uniformity across 200 and 300 mm wafers was performed on a Rudolph Model # Focus Fe IV-D spectroscopic ellipsometer tool using a standard 49 point wafer map.

The dielectric constant of each sample film was determined according to ASTM Standard D150-98. The capacitance-voltage of each film were obtained at 1 MHz with a Solartron Model SI 1260 Frequency Analyzer and MSI Electronics Model Hg 401 single contact mercury probe. The error in capacitance measurements and mercury electrode area (A) was less than 1%. The substrate (wafer) capacitance ($C_{Si}$), background capacitance ($C_b$) and total capacitance ($C_T$) were measured between +20 and -20 volts and the thin film sample capacitance ($C_s$) was calculated by Equation (1):

$$C_s = C_{Si}\,(C_T - C_b)/\,[C_{Si} - (C_T - C_b)] \qquad \text{Equation (1)}$$

The dielectric constant of each film was calculated by Equation (2) wherein d is the film thickness, A is the mercury electrode area, and $\varepsilon_0$ is the dielectric constant in vacuum:

$$\varepsilon = \frac{C_S d}{\varepsilon_0 A} \qquad \text{Equation (2)}$$

The total error of the dielectric constant of the film was expected to be less than 6%.

The elastic modulus for each film was taken from $1\times0.4cm^2$ samples cleaved from the center of the wafer and mounted onto an aluminum stub using a low-melting-temperature adhesive, CRYSTALBOND® which is manufactured by Armco Products Inc., of Valley Cottage, N.Y. Indentation tests were performed on a NANOINDENTER® Dynamic Contact Module (DCM) manufactured by MTS Systems Corporation with an ACCUTIP™ Berkovich diamond tip using the continuous stiffness measurement ("CSM") method described in the reference, Oliver et al., "An improved technique for Determining Hardness and Elastic Modulus Using Load and Displacement Sensing Indentation Experiments", J. Material Research, 1992, 7 [6], pp. 1564-1583, incorporated herein by reference in its entirety. A small oscillation was superimposed on the primary loading signal and the resultant system response was analyzed by means of a frequency-specific amplifier. The excitation frequency was held constant throughout the test at 75 Hz (DCM) and the excitation amplitude was controlled such that the resulting displacement amplitude remained constant at 1 nm (DCM).

Each indentation experiment allowed for a continuous measure of the contact stiffness, S. Using the dynamic measure of S, and established formulae for Young's modulus and hardness (Poisson's Ratio = 0.18 for silica, 0.25 for low κ films), every individual indentation experiment yielded Young's modulus and hardness as a continuous function of surface penetration. An array of 5 to 10 indents was performed on each sample and a distance of approximately 20 - 25 microns separated successive indents. The results from each indentation experiment were examined and any "outliers" were excluded. The results for Young's modulus and hardness vs. penetration for the indentation experiments of each sample were averaged using discrete displacement windows of approximately 5 nm. Using the data in this window, an average, standard deviation, and confidence interval for each sample were then calculated. The same statistics were likewise calculated for the rest of the discrete windows. Hardness results were obtained and averaged

in the same manner. Hardness and Young's modulus were reported as the measured value of hardness at the minimum of the hardness curve (at about 30-50 nm) and the measured value of modulus at the minimum of the modulus curve (at about 30-50 nm). The errors of the modulus and the hardness of the film are expected to be less than 10 percent.

The molecular weight distribution of the film forming composition was measured using low mass gel permeation chromatography (GPC). The samples are analyzed using a Waters Corporation Alliance 2690 HPLC with THF as a mobile phase at 35°C using a flow rate of 1 milliliter / minute; the sample is diluted to approximately 0.2 wt% in fresh THF prior to the separation. The sample results are relative to a poly(styrene) calibration curve ranging from 194 to 70,000 daltons.

The radius of gyration (Rg), defined as the square root of the mean square distance away from the center of gravity of the molecule, was measured using low mass gel permeation chromatography coupled with on-line differential viscometry detection. The calculations for Rg are based on measurement of molecular weight utilizing the concept of universal calibration, which are a direct result of on-line viscometry detection. Light scattering measurements are generally not applicable to polymeric materials with Rg values < 10 nm and could not be used for these film forming compositions. The following conditions were used to measure the Rg of the film forming compositions: Low Mass GPC system: Waters Corporation Alliance Model 2690; Differential refractometer detector: Waters Model 410; Differential viscometry detector: Viscotek Model T60A; Solvent: THF stabilized with BHT; Flow rate: 1.0 ml/minute; Temperature: 35°C; Sample concentration: - 1 weight percent; Calibration standards: Polymer laboratories poly(styrene), 162 to 70,000 mass; Internal standard: toluene, 0.1 weight percent in the mobile phase. By measuring intrinsic viscosity online with a differential viscometry detector for the GPC calibration standards and sample, both the molecular weight and Rg can be calculated using the universal calibration concept.

Surface tension of the film forming composition is measured using the Wilhelmy plate method on a Kruss Digital Tensiometer # K10ST. The Wilhelmy plate method is a universal methods especially suited to check surface tension over long time intervals. A vertical plate, typically made of platinum of know perimeter is attached to a balance and the force due to wetting is measured using a digital tensiometer as the plate is lowered into the film forming solution.

Viscosity measurements were performed using an SR5 controlled stress rheometer from Rheometric Scientific. All measurements were made at 25°C; temperature was controlled using a Peltier heater. A 40 mm parallel plate fixture was used. Samples were loaded onto the bottom plate using a disposable pipette; plate gaps were 0.3 mm nominal. Shear stresses were applied to obtain shear rates between 100 and 1000 $sec^{-1}$ at five evenly spaced points on a logarithmic scale. A total of 45 seconds of settling time and 15 seconds of measurement time were used at each point.

The surface roughness of the film is an indication of striations or other defects, such as holes, dust, in the film's surface. Surface roughness and edge shape is measured on a Tencor P-2 profilometer. To determine surface roughness, the wafer is placed on the sample holder with the area to be scanned about 10mm in from the edge. The scan length is 1 millimeter and sampled every 40 microns. At the beginning of the scan a 2 mg force is applied to the 5 micron tip.

GENERAL PROCESS FOR PREPARING COMPOSITIONS

A composition was prepared by adding one or more hydrophobic and hydrophilic silica sources to a solvent (s) to provide a solution. The porogen is added to the silicates. In a separate container or by sequential addition of the following reagents to the silicates, the catalyst, water (if the reagents do not supply all of the water), and ionic additive are added. If a separate container is used to mix the catalyst and ionic additive, this solution should be added to the silicate solution to provide the composition. Following the addition of the catalyst and ionic additive, the composition is agitated for less than about 5 minutes and aged at room temperature for a period ranging from 1 to 72 hours. Each of the chemical reagents within the composition contained less than 1 ppm of metal impurities. All of the reagents used in the formulations have been purified using packed bed ion exchange resins or distillation to less than 200 ppb of alkali metals using the process described in U. S. Published application 2004-0048960.

Example 1

22.5 g tetraethylorthosilicate (TEOS) and 22.5 g of methyltriethoxysilane (MTES) were added to 100g of 1-pentanol and mixed thoroughly. 9.67g of purified Triton X-114 was added to the silicate solution and agitated to obtain a homogeneous solution. In a separate bottle, 1 g of 2.4wt% tetramethylammonium hydroxide in water (TMAH) was added to 24g of 0.1 M nitric acid ($HNO_3$). The $HNO_3$ solution was added directly to the silicate solution. The entire composition was agitated for -30 minutes.

After allowing the composition to sit at ambient conditions for 12 to 24 hrs., the composition was filtered through a 0.2 micron Teflon filter. Approximately 1.2 milliliters (mls) of composition was dispensed onto a 4" Si wafer in an open bowl configuration while spinning at 500 rpm for 7 seconds. At the completion of the dispense step, the

wafer was accelerated to 1800 rpm for 40 seconds to complete the evaporation process.

The wafer was then calcined in air at 90°C for 90 seconds, 180°C for 90 seconds, and 180 seconds at 400°C to obtain a fully cured low dielectric organosilicate film. The calcined film has a dielectric constant of 2.07, a refractive index of 1.1785, and a film thickness of 4676Å.

Example 2-13:

The same procedure that was used in example 1 was repeated except that 100g of the solvent or a 50/50 mole percent mixture of solvents with the appropriate combination of boiling point, surface tension, viscosity, and solubility parameter were used in place of the 1-pentanol. Examples 2-5 and 12-13 are comparative compositions that use one or more solvents that fall outside the preferred ranges of physical and chemical properties. The properties of films made from compositions 1 through 13 are provided in Table II.

Table II

| Example # | Solvent | Dielectric Constant | Homogenous | Striations | Dewetting | Uniformity |
|---|---|---|---|---|---|---|
| 2 (Comparative) | dipropylene glycol | n/t | yes | yes | yes | no |
| 3 (Comparative) | propylene glycol | n/t | no (emulsion) | yes | yes | no |
| 4 (Comparative) | diacetone alcohol | n/t | no (two-phase) | yes | yes | no |
| 5 (Comparative) | Cyclohexanone | n/t | yes | yes (particles) | no | no |
| 12 (Comparative) | Ethanol | 2.05 | yes | yes | no | yes |
| 13 (Comparative) | ethyl acetate | 2.06 | yes | yes | no | yes |
| 6 | propylene glycol propyl ether | 2.06 | yes | no | no | yes |
| 7 | 2-methyl-1-pentanol | 2.07 | yes | no | no | yes |
| 1 | 1-pentanol | 2.07 | yes | no | no | yes |
| 8 | propylene glycol methyl ether acetate | 1.99 | yes | no | no | yes |
| 9 | 2-methyl-1-pentanol / 4-heptanone | 2.13 | yes | no | no | yes |
| 10 | 2-hexanol / 2-methyl-1-butanol | 2.13 | yes | no | no | yes |
| 11 | 5-methyl-2-hexanol / propylene glycol methyl ether acetate | 2.08 | yes | no | no | yes |

AMBIENT STORAGE STABILITY

Table III provides a comparison of various parameters associated with ambient shelf life for film-forming compositions 1 and 14 through 24. In Table III, thickness stability is defined as a 1.5% change in thickness from its initial value; dielectric constant stability or k stability is defined as a 1% change in dielectric constant from its initial value; and the % of a component removed (e.g., low boiling solvent, solvent, and water) is based upon the total number of moles of each component in the reduced composition divided by the total number of moles available from the initial or non-reduced composition multiplied by 100. As Table III illustrates, exemplary compositions 14, 17, 18, 19, 21, and 23 have ambient storage stability greater than 10 days. The remaining examples are comparative examples wherein the compositions fall outside the desired ranges.

Example 14:

97.3g TEOS, 97.3g MTES, 497.3g of 1-pentanol, and 108.1g of a catalyst solution (103.7g of 0.1 M $HNO_3$, and 4.3g 2.4 wt% TMAH) were combined together and mixed until homogeneous. The solution was stirred at 60°C for 2 hours. After 2 hours at 60°C, the solution was concentrated by removing -20 wt% of the volatile components from the mixture using a rotary evaporator at 60°C (removed 160g of ethanol, water, and pentanol). The solution was cooled back to room temperature. 160g of 1-pentanol was added to the formulation and stirred until homogeneous. 69.9g of Triton X-114 was then added to the solution and mixed to insure homogeneity of the composition.

After aging at room temperature for 16 to 24 hours, the composition was filtered through a 0.2 micron Teflon filter. 4 mls of the filtered composition was dispensed, in a process tool with an open spinning bowl configuration, onto a 8" Si substrate spinning at 500 rpm (dispense time - 8 seconds) before accelerating to 1800 rpm for 25 seconds to dry the film. After spinning the sample, the film was calcined at 140°C for 60 seconds to remove residual solvent and then at 400°C for 180 seconds to remove the porogen. This formulation as processed above was stable for >30 days. The initial film thickness was 0.4587 microns, refractive index of 1.1748, average dielectric constant of 2.45, and modulus of 1.24 Gpa.

Example 15

109.2g TEOS, 109.4g MTES, 557.4g PGPE was charged into a round bottomed flask and mixed thoroughly to create a clear solution. Next, 116.4g 0.1 M $HNO_3$ and 4.9g 2.4 wt% TMAH was added to the flask and mixed thoroughly. The flask was placed on a rotary evaporator and heated at 60°C for 2 hours while rotating. At the completion of the hydrolysis portion, ethanol, water, and PGPE are slowly distilled under vacuum until 5 wt% of the initial solution was removed. At this point the vacuum was turned off and the solution was allowed to react at 60°C for a total of 2 hours after the beginning of the distillation process. After heating the solution, the flask was capped and cooled to room temperature. 45g of PGPE and 103.6g of Triton X-114 were added to the silicate solution. The composition was mixed until the solution is clear and homogeneous.

After aging at room temperature for 16 to 24 hours, the composition was filtered through a 0.2 micron Teflon filter. 1.2 mls of the filtered composition was dispensed, in a process tool with an open spinning bowl configuration, onto a 4-inch Si substrate spinning at 500 rpm (dispense time - 7 seconds) before accelerating to 1800 rpm for 40 seconds to dry the film. After spinning the sample, the film was calcined at 90°C for 90 seconds, 180°C for 90 seconds to remove residual solvent and then at 400°C for 180 seconds to remove the porogen.

Examples 16-20:

The same procedure was used as in example 15 except that the weight percent of the initial solution that was removed during distillation, typically low boiling solvents, water, and solvent, was varied as shown in the table V. The weight of solvent that was added back to the composition equals the weight of low boiling solvent, water, and solvent removed during distillation.

Example 21:

The following reagents, 109.1g TEOS, 109.4g MTES, 557.3g PGPE, 105.4g Triton X-114, and 195.3g of water, were charged into a round bottom flask. The flask was sealed and allowed to sit at room temperature for 1 hour. In a separate container, 116.5g 0.1 M $HNO_3$ and 5.0g 2.4 wt% TMAH were combined and mixed thoroughly. The $HNO_3$ / TMAH solution was then added to the silicate-containing solution and thoroughly mixed. The flask was placed onto a rotovap and heated to 60°C while continuously stirring for 2 hours. After the initial heating, vacuum distillation removed 347.4g of ethanol, water, and PGPE (-30 wt% of the initial formulation) at 60°C for approximately 90 minutes. The

solution was allowed to cool to room temperature. To keep the total weight of solution constant, 347.1 g of PGPE was added back to the formulation. The flask was agitated to ensure that the composition was homogeneous.

After aging at room temperature for 16 to 24 hours, the composition was filtered through a 0.2 micron Teflon filter. 1.2 mls of the filtered composition was dispensed, in a process tool with an open spinning bowl configuration, onto a 4" Si substrate spinning at 500 rpm (dispense time - 7 seconds) before accelerating to 1800 rpm for 4 seconds to dry the film. After spinning the sample, the film was calcined at 90°C for 90 seconds, 180°C for 90 seconds to remove residual solvent and then at 400°C for 180 seconds to remove the porogen.

Example 22:

The following reagents 3.82g TEOS, 3.82g MTES, 33.2g PGPE, 1.86g L101 were mixed together until the solution was clear. Next, 3.51g of water was added to the silicate-containing solution and mixed briefly. In a separate container, 3.54g 0.025 M $HNO_3$ and 0.27g 1.2 wt% TMAH were mixed together. The $HNO_3$/ TMAH solution was added to the silicate-containing solution and stirred until the composition became clear.

After the composition clears, the composition was aged under ambient conditions for 12 to 24 hours before filtering the composition through a 0.2-micron Teflon filter. Approximately 1.2 mls of composition was dispensed, in a process tool with an open spinning bowl configuration, onto a 4" wafer while spinning at 500 rpm for 7 seconds. At the completion of the dispense step the wafer was accelerated to 1800 rpm for 40 seconds to complete the evaporation process.

The wafer was calcined in air at 90°C for 90 seconds, 180°C for 90 seconds, and 180 seconds at 400°C to remove the porogen.

Example 23:

112.5g TEOS, 112.55g MTES, and 575.2g PGPE were mixed together in a round bottom flask. In a separate container, 120.5g of 0.1 M $HNO_3$ and 5.4g of 2.4 wt% TMAH were added together and stirred until all of the heat from the acid-base neutralization had dissipated. The catalyst solution was added to the silicate solution and stirred until a clear solution is obtained. The solution was heated to 60°C under continuous stirring and maintained at a temperature of 60°C for 2 hours. After the hydrolysis of the silicates, the product was vacuum distilled at 60°C to remove ~20 wt% ethanol, water, and PGPE (187.2g of solution). The distillation at 60°C took approximately 45 minutes to complete. The solution was cooled back to room temperature, approximately 1 hour. Next, 187.2g of PGPE and 54.9g of Pluronic L101 were added to the composition, which was agitated until it became homogeneous.

Example 24:

A round bottom flask was charged with 101.3g TEOS, 101.32g MTES, 540.9g of 1-pentanol, and 52.48g Pluronic L-31 EO-PO-EO triblock co-polymer. After mixing the surfactant and silicates together, 93.34g water was added and stirred vigorously for 3-4 minutes. In a separate container, 93.13g 0.025 M $HNO_3$ and 7.51g 1.2 wt% TMAH were mixed together. The $HNO_3$ / TMAH solution was added to the silicate solution. The solution was heated to 60°C under continuous stirring. The solution was maintained at 60°C for 2 hours. After 2 hours, the solution was vacuum distilled at 60°C to remove - 30 wt% of the solution that contained ethanol, water, and pentanol (228.2g of solution). The solution was cooled to room temperature and then filtered through a 0.2-micron Teflon filter. Next, 288.2g of 1-pentanol was added to the composition and stirred until the solution became clear.

Table III: Ambient Shelf Life

| Ex. # | Solvent | Surfactant | Wt. % Solvent Removed During Distillation | Thick-ness Stability | k Stability | Striations | % Low Boiling Solvents | % $H_2O$ Removed | % Solvent Removed |
|---|---|---|---|---|---|---|---|---|---|
| 1 | Pentanol | TRITON™ X-114 | 0 | 15 | 6 | No | 0 | 0 | 0 |
| 14 | Pentanol | TRITON™ 114 | 20 | >30 | >30 | No | 59.7 | 38.9 | 4.4 |
| 15 | PGPE | TRITON™ 114 | 0 | 8 | 4 | Yes | 0 | 0 | 0 |
| 16 | PGPE | TRITON™ X-114 | 5 | >>30 | 3 | Yes | 15.5 | 9.6 | 1 |
| 17 | PGPE | TRITON™ X-114 | 10 | >>30 | >>30 | No | 30.8 | 24.7 | 2.6 |
| 18 | PGPE | TRITON™ X-114 | 20 | >>30 | >>30 | No | 55.8 | 44.6 | 6.5 |
| 19 | PGPE | TRITON™ X-114 | 30 | 33 | 10 | No | 73.6 | 58.4 | 8 |
| 20 | PGPE | TRITON™ X-114 | 50 | 10 | 6 | No | 99.7 | 69.7 | 31.9 |
| 21 | PGPE | TRITON™ X-114/extra $H_2O$ | 30 | >30 | 20 | No | 64.9 | 72.4 | 11.8 |
| 22 | PGPE | L101 | 0 | 5 | 3 | No | 0 | 0 | 0 |
| 23 | PGPE | L101 | 20 | 15 | 14 | No | 72.3 | 52.7 | 11.9 |
| 24 | Pentanol | L31 | 30 | 24 | 8 | No | 75.5 | 60.2 | 9.9 |

Examples 25-49: Effect of Flow Additive within Composition

Table IV summarizes the Surface Tension and viscosity date for certain compositions containing flow additives. Table V summarizes the surface roughness for films of different thickness prepared using film forming compositions containing flow additives and compares them to comparative examples where no flow additive is used. The surface roughness, determined by profilometry, is a measure of the striation height and an indicator of other defects in the film.

Example 25:

The reagents were added sequentially as follows: 22.5g TEOS, 22.5g MTES, 130.5g PGPE, 40g 0.1 M $HNO_3$, 8.3g water, 7.4g 2.4 wt% TMAH, 11.8g Triton X-114. After all of the components of the formulation have been added, the solution was mixed thoroughly for 2-3 minutes. 2.45g of Byk 354 was added drop wise to the formulation and mixed thoroughly. The composition was aged for 12-24 hours prior to filtering through a 0.2μm Teflon filter.
Approximately 1.2 mls of the filtered composition is dispensed, in a process tool with an open spinning bowl configuration, onto a 4" wafer while spinning at 500 rpm for 7 seconds. At the completion of the dispense step the wafer was accelerated to 1800 rpm for 40 seconds to complete the evaporation process.
The wafer was calcined in air at 90°C for 90 seconds, 180°C for 90 seconds, and 180 seconds at 400°C to remove the residual solvents and porogen. This film has ~225Å high striations throughout the film.

Examples 26-35:

Examples 26 through 35 have the same order of addition and reagent amounts as in example 25 except that the type and amount of flow additive in the formulation have been changed as shown in table VI.

Example 36:

The following reagents are added sequentially to a Teflon bottle: 15.2g TEOS, 15.3, MTES, 40.5g PGPE, 16g 0.1 M $HNO_3$, and 0.7g of a 2.4 wt% TMAH solution. The composition was shaken to obtain a clear solution. The porogen, 6.5 g of Triton X-114, was added to the silicate solution and mixed for 2-3 minutes. After the composition was mixed thoroughly, a 20.96g aliquot was taken and added to another container. While the silicate composition was being stirred, 0.05g of ISOPAR™ G was added to the aliquot containing the porogen / silicate composition and mixed for 4-5 minutes.
After aging the composition for 12-24 hours, the composition was filtered through a 0.2 μm Teflon filter. Approximately 1.2 mls of the filtered composition is dispensed, in a process tool with an open spinning bowl configuration, onto a 4" wafer while spinning at 500 rpm for 7 seconds. At the completion of the dispense step the wafer was accelerated to 1800 rpm for 40 seconds to complete the evaporation process.
The wafer was calcined in air at 90°C for 90 seconds, 180°C for 90 seconds, and 180 seconds at 400°C to remove the residual solvent and porogen from the film. This film had ~304Å high striations as measured via profilometry.

Examples 37-43:

These examples are done in the same manner as example 36, except that the BYK additives are added as 0.2 wt% solutions in PGPE. Table VI shows flow additives that moderately or strongly reduce the surface tension, i.e. Byk 331, 307, 333, of the solution minimize the striations in the film. It should also be noted that the use of flow additives in compositions that produce thicker films, i.e. less solvent, may be more effective at reducing surface roughness.

Example 44:

In a Teflon bottle, 22.5g of TEOS, 22.5g MTES, 115g PGPE, 16.1 g of Triton X-114, were combined and no flow additive was added to provide solution A. In a separate container, 24g of 0.1 M $HNO_3$ and 1 g of a solution of 2.4 wt% TMAH were combined to provide solution B. With solution A stirring, solution B was slowly added to solution A and mixed for 15 minutes to homogenize the solution. The composition was aged for 12-24 hours.
After aging, the composition was filtered through a 0.2μm Teflon filter. The filtered composition was mechanically dispensed, in a process tool with an open spinning bowl configuration, onto a 8" wafer spinning at 500 rpm for 8 seconds. The wafer was accelerated to 2000 rpm for 6 seconds to spread the film and dried at 1800 rpm for 25 seconds. The film was then calcined at 140°C for 90 seconds and 400°C for 180 seconds to remove the porogen from the film. This film had 100-200Å high striations as determined via profilometry.

Example 45-49:

Examples 45-49 followed the same mixing protocol and deposition methodology as example 44, except that the appropriate amount of flow additive, as designated in the table V, was added. Based upon the data in the table V, the striations are no longer detectable by profilometry or visible under magnification when the composition contains >17 ppm of surface flow additive that are described as capable of reducing the surface tension of compositions.

Table IV:

| Surface Tension and Viscosity Data | | | |
|---|---|---|---|
| Ex # | Film-Forming Compositions Containing Solvent and Flow Additive (if added) | Surface Tension (dyne/cm) | Viscosity (cP) |
| 1 | 1-pentanol | 25.4 | 4.7 |
| 7 | 2-methyl-1-pentanol | 25.2 | 6.2 |
| 8 | PGMEA | 28.9 | 2.6 |
| 12 (Comparative) | Ethanol | 25.5 | 2.5 |
| 26 | Ethanol / BYKCHEMIE™ 361 | 26 | 2.7 |
| 27 | Ethanol/MODAFLOW™ AQ-3000 | 26.1 | 2.7 |
| 28 | Ethanol/ISOPAR™ G | 25.7 | 2.6 |
| 31 | Ethanol/ BYKCHEMIE™ 331 | 22.6 | 2.8 |
| 32 | Ethanol/ BYKCHEMIE™ 307 | 23 | 2.8 |
| 33 | Ethanol/ BYKCHEMIE™ 333 | 22.3 | 2.7 |
| 34 | Ethanol/ BYKCHEMIE™ 346 | 25.7 | 2.6 |
| 36 | Ethanol/ISOPAR™ G | 26.7 | 5.9 |
| 39 | Ethanol/ BYKCHEMIE™ 302 | 25.1 | 5.9 |
| 40 | Ethanol/ BYKCHEMIE™ 331 | 26.4 | 6 |
| 41 | Ethanol/ BYKCHEMIE™ 307 | 25.1 | 5.9 |
| 42 | Ethanol/ BYKCHEMIE™ 333 | 25.3 | 5.9 |

Table V

| Ex # | Flow Additive | Flow Additive Type | Amt. Flow Additive added (ppm) | Dielectric Constant | Thickness (Å) | Surface Roughness (Å) |
|---|---|---|---|---|---|---|
| Blank Wafer | None | | | | | 50 |
| 25 | BYKCHEMIE™ 354 | Polyacrylate | 10000 | ---- | 4796 | 225 |
| 26 | BYKCHEMIE™ 361 | Polyacrylate | 5000 | 2.1 | 3238 | 165 |
| 27 | MODAFLOW™ AQ3000 | Polyacrylate | 5000 | 2.18 | 5000 | 136 |
| 28 | ISOPAR™ G | paraffinic distillates | 5000 | 2.16 | 3359 | 72 |
| 29 | ISOPAR™ H | paraffinic distillates | 5000 | 2.14 | 3363 | 170 |
| 30 | ISOPAR™ L | paraffinic distillates | 5000 | 2.23 | 3399 | 226 |
| 31 | BYKCHEMIE™ 331 | polyether modified dimethyl siloxane | 5000 | 2.22 | 3362 | 148 |

Table V (continued)

| Ex # | Flow Additive | Flow Additive Type | Amt. Flow Additive added (ppm) | Dielectric Constant | Thickness (Å) | Surface Roughness (Å) |
|---|---|---|---|---|---|---|
| 32 | BYKCHEMIE™ 307 | polyether modified dimethyl siloxane | 5000 | 2.21 | 4734 | 48 |
| 33 | BYKCHEMIE™ 333 | polyether modified dimethyl siloxane | 5000 | 2.22 | 3326 | 71 |
| 34 | BYKCHEMIE™ 346 | polyether modified dimethyl siloxane | 5000 | 2.29 | 3311 | 89 |
| 35 | None (Comparative to Ex. 25-34) | | 0 | 2.26 | 3242 | 110 |
| 36 | ISOPAR™ G | paraffinic distillates | 2380 | 2.2 | 8179 | 304 |
| 37 | ISOPAR™ H | paraffinic distillates | 1430 | 2.17 | 8193 | 201 |
| 38 | ISOPAR™ L | paraffinic distillates | 1910 | 2.19 | 8140 | 120 |
| 39 | BYKCHEMIE™ 302 | polyether modified dimethyl siloxane | 178 | 2.12 | 7832 | 49 |
| 40 | BYKCHEMIE™ 331 | polyether modified dimethyl siloxane | 178 | 2.19 | 7797 | 46 |
| 41 | BYKCHEMIE™ 307 | polyether modified dimethyl siloxane | 178 | 2.13 | 6709 | 95 |
| 42 | BYKCHEMIE™ 333 | polyether modified dimethyl siloxane | 178 | 2.22 | 7733 | 59 |
| 43 | None (Comparative to Ex. 36-42) | | 0 | 2.07 | 8346 | 281 |
| 44 | None (Comparative to Ex. 45-49) | | 0 | | 5154 | 100-200Å |

Table V (continued)

| Ex # | Flow Additive | Flow Additive Type | Amt. Flow Additive added (ppm) | Dielectric Constant | Thickness (Å) | Surface Roughness (Å) |
|---|---|---|---|---|---|---|
| 45 | BYKCHEMIE™ 307 | polyether modified dimethyl siloxane | 6.7 | | 5167 | 50-100Å |
| 46 | BYKCHEMIE™ 307 | polyether modified dimethyl siloxane | 17 | | 5086 | 100Å |
| 47 | BYKCHEMIE™ 307 | polyether modified dimethyl siloxane | 34 | | 5063 | none |
| 48 | BYKCHEMIE™ 307 | polyether modified dimethyl siloxane | 67 | | 5061 | none |
| 49 | BYKCHEMIE™ 307 | polyether modified dimethyl siloxane | 102 | | 5053 | none |

Example 57

12.5 g water and 22.5 g of tetraacetoxysilane (TAS) were added to 40.1 g of 1-propanol and the solution was shaken for 1 hour. The TAS solution was aged for 1 to 24 hours under ambient conditions. A solution of 23.1 g methyltriacetoxysilane (MTAS) and 7.2g 0.025 M $HNO_3$ were added to the TAS solution and the combined solution was aged for approximately one hour. 10.2g of a purified 50 weight percent Tergitol 15-S-5 in 1-propanol solution was added to the silicate solution and agitated to obtain a homogeneous solution. 1.4 g of 1.2wt% tetramethylammonium hydroxide in water (TMAH) was added to the solution. The entire composition was agitated for approximately 1-15 minutes.

After allowing the composition to sit at ambient conditions for 12 to 24 hrs., the composition was filtered through a 0.2 micron Teflon filter. Approximately 1.2 mls of this composition was dispensed, in a process tool with an open spinning bowl configuration, onto a 4" Si wafer while spinning at 500 rpm for 7 seconds. At the completion of the dispense step the wafer was accelerated to 1800 rpm for 40 seconds to complete the evaporation process. The wafer was then calcined in air at 90°C for 90 seconds, 180°C for 90 seconds, and 180 seconds at 400°C to remove residual solvent and porogen. The calcined film had a dielectric constant of 2.06, a refractive index of 1.20, and a film thickness of 5600Å.

Example 58

22.5 g tetraethylorthosilicate (TEOS) and 22.5 g of methyltriethoxysilane (MTES) were added to 100g of PGPE. The solution was mixed thoroughly. 9.67g of purified Triton X-114 was added to the silicate solution and agitated to obtain a homogeneous solution. In a separate bottle, 1 g of 2.4wt% tetramethylammonium hydroxide in water (TMAH) was added to 24g of 0.1 M nitric acid ($HNO_3$). The $HNO_3$ solution was added directly to the silicate solution. The entire composition was agitated for ~30 minutes.

After allowing the composition to sit at ambient temperature, 10 mls of the composition was dispensed, in a process tool with an open spinning bowl configuration, onto an 8" Si wafer at 500 rpm for 8 seconds. At the completion of the dispense step the wafer was accelerated to 2000 rpm for 6 seconds, decelerated to 1200 rpm for 15 seconds, and accelerated to 1800 rpm for 10 seconds to finish the initial film drying. At this point the wafer was decelerated to 1200 rpm for 15 seconds. During this time an EBR solvent, ethylacetoacetate, was dispensed onto the wafer edge. After the EBR solvent was dispensed, the wafer was accelerated to 2000 rpm for 10 seconds to finish drying the film.

Once the film was dry, an isopropanol backside rinse was initiated to remove any particulates or residues from the backside of the wafer. Upon completion of the entire coating process, the bowl was rinsed with isopropanol to remove any material that deposited onto the walls or bottom of the spin bowl. The bowl rinse can be continuous, after each wafer, or after a pre-determined number of wafers.

Example 59

The spin coating recipe used to deposit the film onto 200 and 300 mm wafers in an open bowl configuration was as follows: 2000 rpm for 15 sec (5000 rpm/sec acceleration rate), 500 rpm for 8 sec (1000 rpm/sec acceleration rate, dispense solution), 2000 rpm for 6 sec (30000 rpm/sec acceleration rate, spread), 1200 rpm for 15 sec (3000 rpm/sec acceleration rate, dry 1), 1800 rpm for 10 sec (30000 rpm/sec acceleration rate, dry 2), 1200 rpm for 15 sec (3000 rpm/sec acceleration rate, top side edge bead removal (TSEBR)), and 2000 rpm for 10 sec (1000 rpm/sec acceleration rate, final dry). The wafers can be bare Si (with native oxide or 150A thermal oxide) or Si wafers coated with conventional CVD films, e.g. BLACK DIAMOND™ ("BD"), AURORA™, BLOK™, CORAL™, silica, carbon doped silica, silicon carbides, silicon nitrides, silicon oxynitrides, silicon oxycarbides, used in semiconductor manufacturing. Using the dispense volumes provided in Table VI, an entire 200 or 300 mm wafer can be uniformly covered without any defects.

Table VI :

| Dispense Amounts | | | | | |
|---|---|---|---|---|---|
| Wafer | Dielectric Constant Composition | Size (mm) | Area ($cm^2$) | Amount Composition Dispensed | Milliliters Solution/ $cm^2$ of Wafer |
| Si | 1.9 | 200 | 314 | 1 | 0.00318 |
| Si-Oxide (150 Å) | 1.9 | 200 | 314 | 1 | 0.00318 |
| Si-BD (750Å) | 1.9 | 200 | 314 | 1 | 0.00318 |
| Si-Oxide | 1.9 | 300 | 707 | 3 | 0.00424 |
| Si-BD | 1.9 | 300 | 707 | 3 | 0.00424 |
| Si-BLOK™ | 1.9 | 300 | 707 | 3 | 0.00424 |
| Si | 2.2 | 200 | 314 | 1 | 0.00318 |
| Si-Oxide (150 Å) | 2.2 | 200 | 314 | 1 | 0.00318 |
| Si-BD (750Å) | 2.2 | 200 | 314 | 1 | 0.00318 |
| Si-Oxide | 2.2 | 300 | 707 | 2 | 0.00283 |
| Si-BD | 2.2 | 300 | 707 | 3 | 0.00424 |
| Si-BLOK™ | 2.2 | 300 | 707 | 2 | 0.00283 |

Examples 60A through 60E

Five exemplary compositions containing 22.5 g tetraethylorthosilicate (TEOS) and 22.5 g of methyltriethoxysilane (MTES) and varying amounts of PGPE were prepared and mixed thoroughly. In the following examples, the amount of PGPE that was present in the compositions for a given thickness are provided in table VII. Next, 9.67g of purified Triton X-114 was added to each silicate solution and agitated to obtain a homogeneous solution. In a separate bottle, 1 g of 2.4wt% tetramethylammonium hydroxide in water (TMAH) was added to 24g of 0.1 M nitric acid ($HNO_3$). The $HNO_3$ solution was added directly to the silicate solution. The entire composition is agitated for ~30 minutes.

After allowing the compositions to sit at ambient conditions for 12 to 24 hrs., each composition was filtered through a 0.2 micron Teflon filter. Approximately 1.2 mls of solution was dispensed, in a process tool with an open spinning bowl configuration, onto a 4" Si wafer while spinning at 500 rpm for 7 seconds. At the completion of the dispense step the wafer was accelerated to 1800 rpm for 40 seconds to complete the evaporation process.

Table VII

| Example # | Film Thickness (Å) | g PGPE |
|---|---|---|
| 60A | 3000 | 170 |
| 60B | 4000 | 120 |
| 60C | 5000 | 95 |
| 60D | 8000 | 55 |
| 60E | 9000 | 48 |

Examples 61A through 61B

Five exemplary compositions containing 22.5 g tetraethylorthosilicate (TEOS) and 22.5 g of methyltriethoxysilane (MTES) and varying amounts of PGPE were prepared and mixed thoroughly. In the following examples, the amount of PGPE that was present in the compositions for a given thickness are provided in table VIII. Next, 16.1g of purified Triton X-114 was added to each silicate solution and agitated to obtain a homogeneous solution. In a separate bottle, 1 g of 2.4wt% tetramethylammonium hydroxide in water (TMAH) was added to 24g of 0.1 M nitric acid ($HNO_3$). The $HNO_3$ solution was added directly to each silicate solution. The entire composition was agitated for ~30 minutes.

After allowing the composition to sit at ambient conditions for 12 to 24 hrs., the solution was filtered through a 0.2 micron Teflon filter. Approximately 1.2 mls of the composition was dispensed, in a process tool with an open spinning bowl configuration, onto a 4" Si wafer while spinning at 500 rpm for 7 seconds. At the completion of the dispense step the wafer was accelerated to 1800 rpm for 40 seconds to complete the evaporation process.

Table VIII

| Example # | Film Thickness (Å) | g PGPE |
|---|---|---|
| 61A | 3000 | 200 |
| 61B | 4000 | 150 |
| 61C | 5000 | 120 |
| 61D | 8000 | 76 |
| 61E | 9000 | 67 |

Radius of Gyration

Three exemplary compositions, Examples 60C, 61C, and 18 having PGPE as the solvent were prepared as described herein and the radius of gyration (Rg) results for each example were obtained and are provided in Table IX. Radius of gyration results were obtained through low mass gel permeation chromatography (GPC) coupled with on-line differential viscometry detection using THF at 35°C. The technique and equipment were validated using several standards prior to determining the radius of gyration for our experimental samples, including polystyrene standard 20,650 mass, polyethylene glycol (PEG) 2,500 mass (vendor), PEG 4,885 mass (vendor), polymethylmethacrylate (PMMA) 4,000 mass (vendor). Table IX also provides the results for the polysilicate polymers as measured for each composition using coupled GPC / viscometry technique (if surfactant is present in the formulation the data was fit with the GRAMS Al software package to analyze the data to obtain the Rg for the silicate species). Table IX further illustrates the variation in Rg for exemplary composition 18 during different processing phases.

Table IX

| Ex. # | Composition | Rg (nm) |
|---|---|---|
| 60C | 2.2 k, 5000A, PGPE, X-114 | 1.30 |
| 61C | 1.9 k, 5000A, PGPE, X-114 | 1.26 |
| 18 | Processed formulation (1.9 k, 5000A, PGPE, X-114) | 1.26 |
| 18 | After 2 hrs at 60°C | 1.39 |

Table IX (continued)

| Ex. # | Composition | Rg (nm) |
|---|---|---|
| 18 | mid point in 60C distillation | 1.41 |
| 18 | end of 60C distillation | 1.46 |
| 18 | After addition of PGPE / surfactant | 1.59 |

Uniformity Data

Exemplary film-forming compositions 1, 14, 18, 60B, and 61C were prepared and the uniformity of the film on 200 and 300 mm wafers were analyzed as described herein. For 200 mm wafers, a 49-point wafer map was conducted; for 300 mm waters, a 85-point wafer map was conducted. The results of this analysis is provided in Table X.

Table X

| Example # | Avg. | Max. | Min. | Diff. | Std Dev | % Std. Dev | wafer (mm) |
|---|---|---|---|---|---|---|---|
| Ex. 1 - Wafer #2 | 3511.5 | 3594.9 | 3460.2 | 134.7 | 31.19 | 0.89 | 200 |
| Ex. 1 - Wafer #1 | 3476.8 | 3594.4 | 3405.8 | 188.6 | 49.33 | 1.42 | 200 |
| Ex. 14 - Wafer #2 | 3018.6 | 3052.6 | 2897.6 | 155 | 24.91 | 0.83 | 200 |
| Ex. 14 - Wafer #1 | 4315.4 | 4375.8 | 4263.3 | 112.5 | 22.53 | 0.52 | 200 |
| Ex. 60B - Wafer #2 | 4308.1 | 4337 | 4263.6 | 73.4 | 15.62 | 0.36 | 200 |
| Ex. 60B - Wafer #1 | 4322.8 | 4364.7 | 4264.8 | 99.9 | 21.76 | 0.50 | 200 |
| Ex. 18 - Wafer #2 | 3755.7 | 3804.5 | 3676.2 | 128.3 | 25.08 | 0.67 | 200 |
| Ex. 18 - Wafer #1 | 3729 | 3804 | 3647.2 | 156.8 | 37.89 | 1.02 | 200 |
| Ex. 14 - Wafer #2 | 3041.5 | 3071.7 | 3013.7 | 58 | 12.48 | 0.41 | 300 |
| Ex. 14 - Wafer #1 | 3035.3 | 3063.2 | 3008.1 | 55.1 | 12.08 | 0.40 | 300 |
| Ex. 61C - Wafer #2 | 4711.5 | 4755.5 | 4661.1 | 94.4 | 22.19 | 0.47 | 300 |
| Ex. 61C - Wafer #1 | 4725.5 | 4790 | 4662.7 | 127.3 | 29.9 | 0.63 | 300 |
| Ex. 60B - Wafer #2 | 4143.2 | 4195.5 | 4089.8 | 105.7 | 19.32 | 0.47 | 300 |
| Ex. 60B - Wafer #1 | 4160.1 | 4267.2 | 4130.1 | 137.1 | 20.1 | 0.48 | 300 |

## Claims

1. A composition for producing a silica-based material having a dielectric constant of about 3.7 or less, the composition comprising: an at least one silica source, a solvent, an at least one porogen, optionally a catalyst, and optionally a flow additive wherein the solvent boils at a temperature ranging from 90°C to 170°C and is selected from the group of compounds represented by the following formulas:

   a. $HO-CHR^8-CHR^9-CH_2-CHR^{10}R^{11}$ where $R^8$, $R^9$, $R^{10}$ and $R^{11}$ can independently be an alkyl group ranging from 1 to 4 carbon atoms or a hydrogen atom; and
   b. $R^{12}-CO-R^{13}$ where $R^{12}$ is a hydrocarbon group having from 3 to 6 carbon atoms; $R^{12}$ is a hydrocarbon group having from 1 to 3 carbon atoms; and mixtures thereof.

2. The composition of claim 1 further comprising an ionic additive.

3. The composition of claim 1 wherein the at least one silica source is selected from the group represented by the following formulas:

   a. $R_aSi(OR^1)_{4-a}$, wherein R independently represents a hydrogen atom, a fluorine atom, or a monovalent organic group; $R^1$ represents a monovalent organic group; and a is an integer selected from 1 and 2;.

b. $Si(OR^2)_4$, where $R^2$ represents a monovalent organic group;
c. $R^3_b(R^4O)_{3-b}Si-R^7-Si(OR^5)_{3-c}R^6_c$, wherein $R^4$ and $R^5$ may be the same or different and each represents a monovalent organic group; $R^3$ and $R^6$ may be the same or different; b and c may be the same or different and each independently is a number ranging from 0 to 3; $R^7$ represents an oxygen atom, a phenylene group, or a group represented by $-(CH_2)_n-$, wherein n is an integer ranging from 1 to 6; and mixtures thereof.

**4.** The composition of claim 1 wherein the composition contains 20 to 80 mole percent Si-C bonds relative to the total number of Si atoms within the composition.

**5.** The composition of claim 1 wherein the solvent is selected from alcohol isomers having from 4 to 6 carbon atoms, ketone isomers having from 4 to 8 carbon atoms, and mixtures thereof.

**6.** The composition of claim 5 wherein the solvent is selected from 1-pentanol, 2-pentanol, 2-methyl-1-butanol, 2-methyl-1-pentanol, 2-heptanone, 4-heptanone, 1-tert-butoxy-2-ethoxyethane, 2-methoxyethylacetate, 2,3-dimethyl-3-pentanol, 1-methoxy-2-butanol, 4-methyl-2-pentanol, 1-tert-butoxy-2-methoxyethane, 3-methyl-1-butanol, 2-methyl-1-butanol, 3-methyl-2-pentanol, 1,2-diethoxyethane, 1-butanol, 3-methyl-2-butanol, 5-methyl-2-hexanol, and mixtures thereof.

**7.** The composition of claim 1 wherein the solvent has a total metal content of less than 1 ppm.

**8.** The process of claim 1 wherein the solvent has a total solubility parameter ranging from 15 and 25 $(J/m^3)^{1/2}$.

**9.** The process of claim 1 wherein the solvent has a surface tension ranging from 20 to 50 dyne/cm.

**10.** The process claim 1 wherein the solvent has a viscosity ranging from 0.5 to 7 centipoise as measured by parallel plate methodology.

**11.** The composition of claim 1 wherein the composition has a total metal content of less than 1 ppm.

**12.** The composition of claim 1 wherein a weight ratio of weight of porogen to weight of porogen and weight of $SiO_2$ within the composition ranges from 0.9 to 0.1.

**13.** The composition of claim 1 comprising the catalyst and wherein the catalyst is an acid catalyst.

**14.** The composition of claim 1 that exhibits Newtonian behavior.

**15.** The composition of claim 1 comprising a flow additive.

**16.** The composition of claim 15 wherein the amount of flow additive in the composition is one percent by weight or less.

**17.** The composition of claim 15 wherein the flow additive boils at a temperature of 100°C or greater.

**18.** The composition of claim 15 wherein the flow additive comprises polydimethylsiloxane.

**19.** The composition of claim 15 wherein the flow additive comprises polyether modified dimethylsiloxane.

**20.** The composition of claim 1 wherein the at least one silica source hydrolyzes and condenses and the product of hydrolysis and condensation has a radius of gyration of 5 nanometers or less.

**21.** A composition for forming a silica-based film having a dielectric constant of about 3.7 or less comprising: an at least one silica source, a solvent, optionally at least one porogen, optionally a catalyst, and a flow additive.

**22.** The composition of claim 21 wherein the amount of flow additive in the composition is one percent by weight or less.

**23.** The composition of claim 21 wherein the flow additive boils at a temperature of 100°C or greater.

**24.** The composition of claim 21 wherein the flow additive comprises polydimethylsiloxane.

**25.** The composition of claim 21 wherein the flow additive comprises polyether modified dimethylsiloxane.

**26.** A process for forming a silica-based film with a dielectric constant of 3.7 or less, the process comprising:

providing a composition comprising: an at least one silica source, a solvent, optionally an at least one porogen, optionally an at least one catalyst, and optionally a flow additive wherein the solvent wherein the solvent boils at a temperature ranging from 90°C to 170°C;
depositing the composition onto a substrate using a bowl configuration selected from an open spinning bowl configuration and a semi-closed spinning bowl configuration to form a coated substrate; and
curing the coated substrate to form the silica-based film.

**27.** The process of claim 26 wherein the depositing is conducted using the open spinning bowl configuration.

**28.** The process of claim 26 wherein the depositing is conducted using the semi-closed spinning bowl configuration.

**29.** The process of claim 26 wherein the solvent comprises one or more functionalities selected from hydroxyl, carbonyl, ester, and combinations thereof.

**30.** The process of claim 26 wherein the solvent boils at a temperature ranging from 120 to 170°C.

**31.** The process of claim 26 wherein the solvent has a total solubility parameter ranging from 15 and 25 $(J/m^3)^{1/2}$.

**32.** The process of claim 26 wherein the solvent has a surface tension ranging from 20 to 50 dyne/cm.

**33.** The process claim 26 wherein the solvent has a viscosity ranging from 0.5 to 7 centipoise as measured by parallel plate methodology.

**34.** The process of claim 26 wherein the solvent is selected from the group of compounds represented by the following formulas:

a. $HO-CHR^8-CHR^9-CH_2-CHR^{10}OR^{11}$ where $R^8$, $R^9$, $R^{10}$ and $R^{11}$ can independently be an alkyl group ranging from 1 to 4 carbon atoms or a hydrogen atom; and
b. $R^{12}-CO-R^{13}$ where $R^{12}$ is a hydrocarbon group having from 3 to 6 carbon atoms; $R^{13}$ is a hydrocarbon group having from 1 to 3 carbon atoms; and mixtures thereof.

**35.** The process of claim 34 wherein the solvent is selected from alcohol isomers having from 4 to 6 carbon atoms, ketone isomers having from 4 to 8 carbon atoms, linear or branched hydrocarbon acetates wherein the hydrocarbon has from 4 to 6 carbon atoms, ethylene glycol ethers, propylene glycol ethers, ethylene glycol ether acetates, propylene glycol ether acetates, and mixtures thereof.

**36.** The process of claim 35 wherein the solvent is selected from 1-pentanol, 2-pentanol, 2-methyl-1-butanol, 2-methyl-1-pentanol, 2-ethoxyethanol, 2-propoxyethanol, 1-propoxy-2-propanol, 2-heptanone, 4-heptanone, 1-tert-butoxy-2-ethoxyethane, 2-methoxyethylacetate, propylene glycol methyl ether acetate, pentyl acetate, 1-tert-butoxy-2-propanol, 2,3-dimethyl-3-pentanol, 1-methoxy-2-butanol, 4-methyl-2-pentanol, 1-tert-butoxy-2-methoxyethane, 3-methyl-1-butanol, 2-methyl-1-butanol, 2-methoxyethanol, 3-methyl-2-pentanol, 1,2-diethoxyethane, 1-methoxy-2 propanol, 1-butanol, 3-methyl-2-butanol, 5-methyl-2-hexanol, and mixtures thereof.

**37.** The process of claim 35 wherein the solvent is selected from ethylene glycol ethers, propylene glycol ethers, ethylene glycol ether acetates, propylene glycol ether acetates, and mixtures thereof.

**38.** The process of claim 26 wherein the at least one silica source hydrolyzes and condenses and the product of hydrolysis and condensation has a radius of gyration of 5 nanometers or less.

**39.** A silica-based film formed by the process of claim 26.

**40.** The silica-based film of claim 39 comprising 20 to 80 mole percent Si-C bonds to the total number of Si atoms.

**41.** The silica-based film of claim 39 comprising 500 ppm or less of an amine or a hydroxide.

**42.** The silica-based film of claim 39 comprising pores.

**43.** The silica-based film of claim 39 wherein the film exhibits a film uniformity of 5% or less.

**44.** A process for forming a silica-based film having a dielectric constant of 3.7 or less, the process comprising:

providing a composition comprising: an at least one silica source wherein the at least one silica source partially hydrolyzes to provide a low boiling solvent, an at least one solvent, water, and a catalyst wherein the solvent boils at a temperature ranging from 90°C to 170°C and is selected from the group of compounds represented by the following formulas:

a. $HO\text{-}CHR^8\text{-}CHR^9\text{-}CH_2\text{-}CHR^{10}R^{11}$ where $R^8$, $R^9$, $R^{10}$ and $R^{11}$ can independently be an alkyl group ranging from 1 to 4 carbon atoms or a hydrogen atom; and
b. $R^{12}\text{-}CO\text{-}R^{13}$ where $R^{12}$ is a hydrocarbon group having from 3 to 6 carbon atoms; $R^{13}$ is a hydrocarbon group having from 1 to 3 carbon atoms; and mixtures thereof.

removing from the composition from about 20 to about 75% of the total number of moles of low boiling solvents and from 20 to 80% of the total number of moles of water to provide a reduced composition;
depositing the reduced composition onto a substrate using a bowl configuration selected from an open spinning bowl configuration and a semi-closed spinning bowl configuration to form a coated substrate; and
curing the coated substrate to form the silica-based film.

**45.** The process of claim 44 further comprising adding to the reduced composition solvent prior to depositing.

**46.** The process of claim 44 where the removing is conducted by heating the composition to a temperature ranging from 30 and 100°C.

**47.** The process of claim 44 where the removing is conducted by vacuum distillation.

**48.** The process of claim 44 wherein the composition further comprises at least one porogen.

**49.** The process of claim 44 wherein the depositing is conducted using the open spinning bowl configuration.

**50.** The process of claim 44 wherein the depositing is conducted using the semi-closed spinning bowl configuration.

**51.** The process of claim 44 wherein the composition comprises 1 ppm or less of metals.

**52.** The process of claim 44 wherein the composition further comprises an ionic additive.

**53.** The process of claim 44 wherein the reduced composition has an ambient temperature storage stability of 10 days or greater.

**54.** The process of claim 44 wherein the at least one silica source hydrolyzes and condenses and the product of hydrolysis and condensation has a radius of gyration of 5 nanometers or less.

**55.** A silica-based film formed by the process of claim 44.

**56.** The silica-based film of claim 55 wherein the film exhibits a film uniformity of 5% or less.

**57.** A process for forming a silica-based film with a dielectric constant of 3.7 or less, the process comprising:

providing a composition comprising an at least one silica source, a solvent, optionally at least one porogen, optionally a catalyst, and a flow additive;
depositing 3 milliliters or less of the composition onto a substrate to form a coated substrate wherein the depositing is conducted in a continuous stream; and
curing the coated substrate to one or more temperatures for a time sufficient to form the silica-based film.

**58.** The process of claim 57 wherein the substrate comprises a 300 mm wafer and the amount of composition to square

area of substrate ranges from 0.00141 to 0.0170 cc/$cm^2$.

**59.** The process of claim 57 wherein the substrate comprises a 200 mm wafer and the amount of composition to square area of substrate ranges from 0.00159 to 0.0255 cc/$cm^2$.